# EUROPÄISCHE PATENTSCHRIFT

(11) **EP 1 535 115 B1**
(45) Veröffentlichungstag und Bekanntmachung des Hinweises auf die Patenterteilung: **28.06.2006**
(21) Anmeldenummer: 03798112.3
(22) Anmeldetag: 20.08.2003
(51) Int. Cl.: G03F 7/20

(54) **VERFAHREN UND VORRICHTUNG ZUM HERSTELLEN VON BELICHTETEN STRUKTUREN**
METHOD AND DEVICE FOR PRODUCING EXPOSED STRUCTURES
PROCEDE ET DISPOSITIF POUR PRODUIRE DES STRUCTURES EXPOSEES

(30) Priorität: 03.09.2002 DE 10242142
(43) Veröffentlichungstag der Anmeldung: 01.06.2005
(73) Patentinhaber: KLEO Halbleitertechnik GmbH & Co KG, 88069 Tettnang (DE)
(72) Erfinder: OPOWER, Hans, 82152 Krailling (DE); SCHARL, Stefan, 88142 Wasserburg (DE); LEINENBACH, Dirk, 66571 Habach (DE)
(74) Vertreter: Hoeger, Stellrecht & Partner Patentanwälte
(86) Internationale Anmeldenummer: PCT/EP2003/009215
(87) Internationale Veröffentlichungsnummer: WO 2004/029721

(56) Entgegenhaltungen:
- WO-A-01/18606
- US-A- 5 343 271
- US-A- 5 909 658
- US-A- 6 002 466
- US-A1- 2002 030 733
- US-B1- 6 268 929
- GRENON B J ET AL: "A New Mask Lithography Tool for Advanced Mask Manufacturing" MICROELECTRONIC ENGINEERING, ELSEVIER PUBLISHERS BV., AMSTERDAM, NL, Bd. 27, Nr. 1, 1. Februar 1995 (1995-02-01), Seiten 225-230, XP004025070 ISSN: 0167-9317

## Beschreibung

Die Erfindung betrifft ein Verfahren zum Herstellen von belichteten Strukturen auf einer Vielzahl von auf mindestens einem Substratkörper angeordneten Baugruppen mittels einer Belichtungseinrichtung, bei welcher mindestens ein auf einem Substratträger angeordneter Substratkörper und die Belichtungseinrichtung relativ zueinander in einer Hauptrichtung und quer zu dieser in einer Nebenrichtung bewegt werden, wobei auf mindestens einem Teil der Baugruppen identische Strukturen hergestellt werden.

Ein derartiges Verfahren ist aus dem Stand der Technik, wie zum Beispiel aus der Veröffentlichung von Grenon B. J. et al. "A New Mask Lithography Tool for Advanced Mask Manufacturing"; Microelectronic Engineering; Feb. 1995, vol. 27, Seiten 225-230, ISSN 0167-9317, XP004025070 bekannt, wobei das Problem in der mangelnden Effizienz dieses Verfahrens besteht.

Der Erfindung liegt daher die Aufgabe zugrunde, ein Verfahren zum Herstellen von belichteten Strukturen der gattungsgemäßen Art derart zu verbessern, daß dieses möglichst effizient arbeitet.

Diese Aufgabe wird bei einem Verfahren zum Herstellen von belichteten Strukturen gemäß Anspruch 1 dadurch gelöst, daß jede der identischen Strukturen durch Belichten des Substratkörpers im Bereich der jeweils vorgesehenen Baugruppe innerhalb einer Vielzahl von sich in der Hauptrichtung erstreckenden und in der Nebenrichtung nebeneinanderliegenden Makrozeilen hergestellt wird, daß jede der Makrozeilen eine Vielzahl von sich in der Hauptrichtung erstreckenden und in der Nebenrichtung nebeneinanderliegenden Zeilen umfaßt, daß mit der Belichtungseinrichtung bei einem einmaligen Durchlaufen eines Belichtungsweges alle von diesem Belichtungsweg erfaßten und mit identischen Strukturen zu versehenden Baugruppen im Bereich derselben Makrozeile der Vielzahl von Makrozeilen belichtet werden, daß die Belichtungseinrichtung eine Vielzahl von Lichtquellen und eine diese im wesentlichen gleichzeitig ansteuernde Steuerung mit einem Steuerungsspeicher aufweist, welcher so aufgebaut ist, daß aus diesem bereits abgespeicherte Datensätze der Makrozeile, in deren Bereich belichtet wird, ausgelesen werden können, während Datensätze einer weiteren Makrozeile abgespeichert werden.

Der Vorteil der erfindungsgemäßen Lösung ist darin zu sehen, daß der Steuerungsspeicher dadurch effizient genutzt werden kann, daß aus diesem einerseits die zum Belichten herangezogenen Datensätze der entsprechenden Makrozeile ausgelesen werden können, während Datensätze einer weiteren Makrozeile abgespeichert werden können und daß außerdem die Zeit, während welcher die zum Belichten herangezogenen Datensätze ausgelesen werden, dadurch möglichst groß gehalten wird, daß der Belichtungsweg sich über mehrere Baugruppen erstreckt, so daß wiederum ein möglichst großer Zeitraum zum Abspeichern von Datensätzen der weiteren, für das spätere Belichten vorgesehenen Makrozeile zur Verfügung steht.

Dadurch ist die Möglichkeit geschaffen, die Baugruppen des mindestens einen Substratkörpers möglichst ohne Unterbrechung der Relativbewegung zwischen Belichtungseinrichtung und Substratträger zu belichten und somit unnötige Pausen zu vermeiden, so daß insgesamt die Belichtung der Baugruppen auf dem Substratkörper mit größtmöglicher Effizienz erfolgt.

Unter einem Belichtungsweg ist dabei der Weg zu verstehen, der über alle diejenigen Baugruppen hinweg verläuft, bei welchen eine Belichtung im Bereich derselben Makrozeilen erfolgt, wobei auf dem Wegabschnitt zwischen aufeinanderfolgenden Baugruppen oder auch auf anderen Wegabschnitten nicht stets eine tatsächliche Belichtung des Substrats erfolgen muß.

Beispielsweise ist es im Rahmen der erfindungsgemäßen Lösung auch denkbar, unterschiedliche Arten von Baugruppen auf einem Substrat effizient herzustellen, da aufgrund der erfindungsgemäßen Ausbildung des Steuerungsspeichers die Möglichkeit besteht, bereits während dem Auslesen der Makrozeilen für die eine Art von Baugruppen bereits Makrozeilen für die andere Art von Baugruppen zu speichern und somit nahtlos vom Belichten der einen Art von Baugruppen auch auf das Belichten der anderen Art von Baugruppen übergehen zu können.

Besonders vorteilhaft ist ein erfindungsgemäßes Verfahren, wenn der Belichtungsweg mindestens so lange gewählt wird, daß die Zeit zum Durchlaufen desselben mindestens der Zeit entspricht, die für ein Abspeichern mindestens der Hälfte der Datensätze der weiteren Makrozeile in dem Steuerungsspeicher benötigt wird.

Diese Vorgehensweise erlaubt es, den Steuerungsspeicher hinsichtlich seiner Größe so zu wählen, daß er in der Lage ist, ungefähr die Hälfte der für eine Art von Baugruppen erforderlichen Makrozeilen zu speichern, da während des Auslesens dieser Makrozeilen zum Belichten im Bereich derselben weitere Makrozeilen jeweils gespeichert werden können.

Eine noch größere Reduktion des Steuerungsspeichers läßt sich dann erreichen, wenn der Belichtungsweg mindestens so lange gewählt wird, daß die Zeit zum Durchlaufen desselben mindestens der Zeit entspricht, die für ein Abspeichern von mindestens zwei Drittel der Datensätze der weiteren Makrozeile in dem Steuerungsspeicher benötigt wird.

Eine besonders optimale Konfiguration sieht vor, daß der Belichtungsweg mindestens so lange gewählt wird, daß die Zeit zum Durchlaufen desselben mindestens der Zeit entspricht, die für ein Abspeichern der Datensätze der weiteren Makrozeile in dem Steuerungsspeicher benötigt wird.

In diesem Fall ist es theoretisch lediglich erforderlich, den Steuerungsspeicher so groß zu wählen, daß zwei Makrozeilen gespeichert werden können, nämlich die Makrozeile, deren Belichtung in dem jeweiligen Moment erfolgt und deren Datensätze somit ausgelesen werden, während die Datensätze der anderen Makrozeile, im Bereich von welcher eine Belichtung als nächstes erfolgen soll, während des Durchlaufens des Belichtungswegs eingelesen werden können.

Hinsichtlich der Führung des Belichtungsweges sind dabei die unterschiedlichsten Lösungen denkbar.

Beispielsweise ist es denkbar, daß sich der Belichtungsweg nur über einen Substratkörper erstreckt.

Um den Belichtungsweg jedoch möglichst groß zu halten, ist vorzugsweise vorgesehen, daß sich der Belichtungsweg über mehrere Substratkörper erstreckt.

Ferner ist es - insbesondere um die Bewegung des Substratträgers möglichst einfach zu gestalten - von Vorteil, wenn der Belichtungsweg in der Hauptrichtung geradlinig verläuft, da dann während der Relativbewegung zwischen der Belichtungseinrichtung und dem Substratträger in der Hauptrichtung keine ergänzende Bewegung in der Nebenrichtung erforderlich ist und damit die Präzision besser und die Geschwindigkeit der Belichtung größer ist.

Besonders einfach ist es, wenn der Belichtungsweg ausschließlich und geradlinig in der Hauptrichtung verläuft, da dann für einen Belichtungsweg jeweils nur eine Bewegung in der Hauptrichtung erforderlich ist und nach einer sich anschließenden Bewegung in der Nebenrichtung ein weiterer Belichtungsweg begonnen werden kann.

Es ist aber auch denkbar, den Belichtungsweg so zu wählen, daß der Belichtungsweg in der Haupt- und der Nebenrichtung verläuft.

Dabei wäre es beispielsweise denkbar, den Belichtungsweg so verlaufen zu lassen, daß dieser einmal in der Hauptrichtung, dann mindestens einmal in der Nebenrichtung und dann mindestens noch einmal erneut in der Hauptrichtung, jedoch entgegengesetzt, verläuft.

Eine zur Verlängerung des Belichtungsweges besonders bevorzugte Lösung sieht dabei vor, daß der Belichtungsweg mäanderförmig verläuft, wobei die Mäander vorzugsweise zumindest in der Hauptrichtung geradlinig verlaufende Abschnitte aufweisen.

Auch hinsichtlich der Anordnung der Baugruppen gibt es Möglichkeiten, die Effizienz des erfindungsgemäßen Verfahrens zu steigern.

So ist es besonders günstig, wenn die Baugruppen in sich parallel zur Hauptrichtung erstreckenden Reihen auf den Substratkörpern angeordnet sind, da sich dann die Belichtungswege günstigerweise so legen lassen, daß sie geradlinig in der Hauptrichtung verlaufende Abschnitte aufweisen.

Besonders effizient ist dabei eine Anordnung, bei welcher der Belichtungsweg mindestens eine Reihe von Baugruppen umfaßt.

Noch vorteilhafter läßt sich der Belichtungsweg dann legen, wenn dieser alle in einer in der Hauptrichtung verlaufenden Reihe angeordneten Baugruppen auf einem Substratträger umfaßt, um somit bei einer einfachen Art der Führung des Belichtungswegs eine möglichst große Länge und somit eine möglichst große Zeit zum Durchlaufen des Belichtungswegs zu erreichen.

Es ist aber auch denkbar, den Belichtungsweg so zu führen, daß er mehrere Reihen von Baugruppen erfaßt.

Um die Bewegung in der Nebenrichtung möglichst klein zu halten und somit die Zeit zur Bewegung in der Nebenrichtung möglichst kurz zu halten, ist vorzugsweise vorgesehen, daß die mehreren Reihen von Baugruppen nebeneinander liegen.

Eine bevorzuge Ausführungsform einer erfindungsgemäßen Lösung sieht vor, daß der Belichtungsweg eine Reihe von Baugruppen erfaßt und dann quer zur Hauptrichtung auf eine weitere Reihe von Baugruppen wechselt und diese erfaßt.

Vorzugsweise ist dabei vorgesehen, daß der Belichtungsweg diese weitere Reihe von Baugruppen in umgekehrter Richtung durchläuft als die eine Reihe von Baugruppen.

Besonders zweckmäßig ist es dabei, wenn die weitere Reihe die in der Nebenrichtung auf die eine Reihe nächstfolgende Reihe ist.

Prinzipiell wäre es denkbar die Vielzahl von Zeilen einer Makrozeile durch eine einzige Lichtquelle zu belichten, die dann jeweils über die Vielzahl der Zeilen schnell hin- und herbewegt werden muß.

Um jedoch mit möglichst großer Geschwindigkeit in der Hauptrichtung belichten zu können und somit eine möglichst große Effizienz zu erreichen, ist vorzugsweise vorgesehen, daß zum Belichten der Vielzahl von Zeilen einer Makrozeile die gesamte Vielzahl von Lichtquellen der Belichtungseinrichtung vorgesehen ist, so daß die Belichtungseinrichtung in der Lage ist, mit sämtlichen zur Verfügung stehenden Lichtquellen im Bereich einer Makrozeile die Belichtung durchzuführen.

Dabei wird die gesamte Vielzahl der Lichtquellen der Belichtungseinrichtung über die Steuerung gleichzeitig betrieben, um mit möglichst großer Geschwindigkeit in der Hauptrichtung und somit möglichst großer Effizienz die Belichtung im Bereich der Makrozeile durchführen zu können.

Eine besonders günstige Konzeption, die einerseits das Vorhalten der Datensätze für die Vielzahl von Makrozeilen mindestens einer Baugruppe gewährleistet, andererseits aber auch einen möglichst schnellen Zugriff auf die Datensätze der Makrozeile, im Bereich welcher gerade eine Belichtung erfolgen soll, sieht vor, daß der Steuerungsspeicher über eine Schnittstelle mit mindestens einem Hauptspeicher, der mindestens die Datensätze der Vielzahl von Makrozeilen einer Baugruppe speichert, kommuniziert.

Hinsichtlich der Ausbildung des Steuerungsspeichers wurden bislang keine näheren Angaben gemacht. Um diesen einerseits kostengünstig und andererseits möglichst effizient arbeitend ausbilden zu können, ist vorzugsweise vorgesehen, daß der Steuerungsspeicher mehrere Steuerungsspeichermodule umfaßt und daß die Steuerung mit den mehreren Steuerungsspeichermodulen des Steuerungsspeichers gleichzeitig kommuniziert.

Damit ist die Möglichkeit gegeben, einerseits durch die Steuerungsspeichermodule eine ausreichend große Kapazität des Steuerungsspeichers zu erreichen, andererseits aber gleichzeitig auf einen möglichst großen Bereich des Steuerungsspeichers gleichzeitig zugreifen zu können.

Hinsichtlich der Zusammenfassung und des Einsatzes der mehreren Steuerungsspeichermodule hat es sich als besonders vorteilhaft erwiesen, wenn mehrere Steuerungsspeichermodule mittels eines Steuerungsmoduls zu einer Steuerungsspeichereinheit zusammengefaßt sind und über diese mit der Steuerung kommunizieren.

Vorzugsweise ist dabei ebenfalls vorgesehen, daß über die Steuerungsmodule auch ein Abspeichern von Datensätzen aus dem Hauptspeicher in den Steuerungsspeichermodulen erfolgt.

Hinsichtlich des Datenformats, in welchem die Datensätze im Hauptspeicher und im Steuerungsspeicher gespeichert sind, wurden bislang keine näheren Angaben gemacht.

Beispielsweise ist es denkbar, die Datensätze grundsätzlich in einem maschinennahen Datenformat zu speichern, so daß sie in diesem Datenformat auch vom Hauptspeicher in den Steuerungsspeicher übergeben werden können.

Um die Daten im Hauptspeicher effizienter speichern und auslesen zu können, ist vorzugsweise vorgesehen, daß die Datensätze in dem Hauptspeicher in einem volumenreduzierten Datenformat gespeichert sind und daß vor dem Einlesen der Datensätze in den Steuerungsspeicher eine Wandlung in ein maschinennahes Datenformat durchgeführt wird.

Beispielsweise ist ein volumenreduziertes Datenformat ein Vektordatenformat. Es kann aber auch ein anderes volumenreduziertes Datenformat sein.

Vorzugsweise ist das maschinennahe Datenformat ein Pixeldatenformat, das für die Ansteuerung der einzelnen Lichtquellen besonders geeignet ist, es ist aber auch ein anderes maschinennahes Datenformat denkbar.

Die Wandlung des Datenformats könnte beispielsweise unmittelbar beim Auslesen aus dem Hauptspeicher erfolgen. Besonders günstig ist es jedoch, wenn die Wandlung des Datenformats unmittelbar vor einer Datenübergabe an das Steuerungsmodul erfolgt, um somit bis zur Übertragung der Daten auf das Steuerungsmodul die Datenübertragung mit dem die Übertragungszeit verkürzenden volumenreduzierten Datenformat durchführen zu können.

Besonders günstig ist es dabei, wenn der Steuerungsspeicher in mehrere Steuerungsspeichereinheiten aufgeteilt ist und somit die Steuerung zum gleichzeitigen Ansteuern der Lichtquellen Datensätze aus mehreren Steuerungsspeichereinheiten erhält.

Hinsichtlich der Größe des Steuerungsspeichers wurden im Zusammenhang mit der bisherigen Erläuterung der einzelnen Ausführungsbeispiele keine näheren Angaben gemacht. So sieht eine besonders vorteilhafte Lösung vor, daß der der Steuerung zugeordnete Steuerungsspeicher zur Speicherung von mindestens zwei Makrozeilen ausgelegt ist.

Neben dieser Mindestgröße ist es ebenfalls vorteilhaft, wenn der der Steuerung zugeordnete Steuerungsspeicher zur Speicherung von weniger als der Hälfte der Vielzahl von Makrozeilen einer Baugruppe ausgelegt ist, um den Steuerungsspeicher möglichst kostengünstig realisieren zu können.

Noch besser ist es, wenn der der Steuerung zugeordnete Steuerungsspeicher zur Speicherung von weniger als einem Viertel der Vielzahl von Makrozeilen einer Baugruppe ausgelegt ist.

Die Vielzahl von Lichtquellen, die erfindungsgemäß dazu eingesetzt ist, die Belichtung im Bereich einer Makrozeile durchzuführen, könnte hinsichtlich der Realisierung der Ansteuerung derselben so ausgeführt sein, daß die Vielzahl der Lichtquellen keinerlei Unterteilung mehr erfährt.

Die Ansteuerung der Lichtquellen läßt sich jedoch effizienter gestalten, wenn die Vielzahl von Lichtquellen aus einer Mehrzahl von Lichtquellengruppen gebildet ist, wobei jede Lichtquellengruppe wiederum eine Vielzahl von Lichtquellen aufweist.

Ein besonders vorteilhaftes Steuerungskonzept sieht dabei vor, daß jeder Lichtquellengruppe eine eigene Gruppensteuerung zugeordnet ist und durch diese Gruppensteuerung die Lichtquellen der Lichtquellengruppe ausschließlich und unabhängig von den anderen Lichtquellengruppen gesteuert werden.

Im Zusammenhang mit der Beschreibung der bisherigen Ausführungsbeispiele wurde nicht näher auf die Positionierung der Belichtungseinrichtung und der Substratkörper relativ zueinander in der Nebenrichtung, insbesondere auf die Korrektur von Positionsfehlern der Substratkörper relativ zur Belichtungseinrichtung, eingegangen.

Prinzipiell ist es denkbar, alle Positionsfehler der Substratkörper in der Nebenrichtung dadurch zu korrigieren, daß die Antriebseinrichtung für die Positionierung in der Nebenrichtung entsprechend gesteuert wird und damit eine entsprechende Positionierung des Substratträgers korrigiert wird.

Eine besonders vorteilhafte Lösung sieht jedoch vor, daß die Zahl der Strukturzeilen, welche die Struktur der Baugruppe definieren, kleiner ist als die Gesamtzahl der Zeilen, in welchen mittels der Belichtungseinrichtung eine Belichtung im Bereich der Baugruppe durchgeführt werden kann, und daß eine Feinpositionierung in der Nebenrichtung durch eine Variation der Zuordnung der Strukturzeilen zu den mit der Belichtungseinrichtung belichtbaren Zeilen erfolgt.

Der Vorteil dieser Lösung ist darin zu sehen, daß zumindest die Feinpositionierung geradliniger, paralleler Bahnen in der Nebenrichtung nicht durch eine physikalische Verschiebung des Substratträgers erfolgen muß, sondern durch die Zuordnung der Strukturzeilen zu den mit der Belichtungseinrichtung belichtbaren Zeilen mittels der Software, so daß die mit einer physikalischen Positionierung aufgrund der Massenträgheit bedingten Verzögerungseffekte zumindest hinsichtlich dieser Feinpositionierung vermieden werden können. Es ist die Feinpositionierung mittels der Software in umfassenderer Weise, beispielsweise auch bei nicht geradlinigen oder nicht parallelen Bahnen durchzuführen.

Besonders schnell ist die Feinpositionierung dann realisierbar, wenn die Veränderung der Zuordnung durch die Steuerung für die Lichtquellen ausgeführt wird, da in diesem Fall unmittelbar vor der eigentlichen Belichtung des Substrats noch eine Korrektur mit einer Zeitkonstante realisierbar ist, die sehr klein ist.

Eine besonders günstige Lösung sieht dabei vor, daß in dem Steuerungsspeicher zu jeder Makrozeile Datensätze einer Zahl von Strukturzeilen gespeichert werden, die größer ist als die Vielzahl der im Bereich dieser Makrozeile durch die Belichtungseinrichtung belichtbaren Zeilen, so daß im Bereich jeder Makrozeile unmittelbar eine Korrektur von Positionsfehlern des Substratkörpers in der Nebenrichtung ausführbar ist.

Insbesondere dann, wenn die Lichtquellen zu Lichtquellengruppen zusammengefaßt sind, sieht eine vorteilhafte Lösung vor, daß der Gruppensteuerung Datensätze für eine Teilmenge der Strukturzeilen der zu belichtenden Struktur zur Verfügung gestellt werden, wobei die Zahl der Strukturzeilen der Teilmenge größer ist als die tatsächlich von der Lichtquellengruppe innerhalb eines Gruppenstreifens belichtbare Zahl von Zeilen.

Insbesondere ist dabei vorgesehen, daß die den nebeneinanderliegenden Lichtquellengruppen zur Verfügung gestellten Datensätze von Teilmengen der Strukturzeilen der zu belichtenden Struktur Strukturzeilen umfassen, die in beiden Teilmengen enthalten sind.

Zweckmäßigerweise bilden dabei die in beiden Teilmengen enthaltenen Strukturzeilen einen Überlappungsbereich, wobei die übrigen Strukturzeilen der Teilmengen jeweils auf gegenüberliegenden Seiten des Überlappungsbereichs liegen.

Hinsichtlich der mit jeder Lichtquelle belichtbaren Zeilen wurden bislang keine näheren Angaben gemacht.

Prinzipiell wäre es denkbar, für jede zu belichtende Zeile eine Lichtquelle vorzusehen. Besonders günstig ist es jedoch, wenn mit jeder Lichtquelle ein mehrere Zeilen umfassender Zeilenstreifen belichtbar ist.

Um die Effizienz des erfindungsgemäßen Verfahrens zu erhöhen, ist es ferner vorteilhaft, wenn mehrere Belichtungsvorrichtungen, jeweils umfassend einen Substratträger und eine Belichtungseinrichtung, die eine Relativbewegung zueinander ausführen, eingesetzt werden.

Damit läßt sich in einfacher Weise die Zahl der hergestellten Baugruppen pro Zeiteinheit vergrößern.

Besonders günstig ist es dabei, wenn bei zwei Belichtungsvorrichtungen die Relativbewegungen in der Hauptrichtung gegenläufig erfolgen, um die durch die Massenträgheit entstehenden Effekte möglichst weitgehend zu kompensieren.

Eine weitere vorteilhafte Lösung sieht vor, daß bei zwei Belichtungsvorrichtungen die Relativbewegungen in der Nebenrichtung gegenläufig erfolgen, um ebenfalls die Auswirkungen der Massenträgheit zu kompensieren.

Eine besonders günstige Lösung sieht vor, daß vier Belichtungsvorrichtungen eingesetzt werden und daß jeweils paarweise die Relativbewegungen in der Hauptrichtung und die Relativbewegungen in der Nebenrichtung gegenläufig erfolgen.

Die Erfindung betrifft aber auch eine Vorrichtung zum Herstellen von belichteten Strukturen auf mindestens einem Substratkörper mittels einer Belichtungseinrichtung, bei welcher mindestens ein auf einem Substratträger angeordneter Substratkörper und die Belichtungseinrichtung relativ zueinander in einer Hauptrichtung und quer zu dieser in einer Nebenrichtung bewegbar sind.

Die Eingangs gestellte Aufgabe wird bei dieser Vorrichtung, erfindungsgemäß dadurch gelöst, daß die belichteten Strukturen durch Belichten des Substratkörpers innerhalb einer Vielzahl von sich in der Hauptrichtung erstreckenden und in der Nebenrichtung nebeneinanderliegenden Makrozeile herstellbar ist, daß jede der Makrozeilen eine Vielzahl von sich in der Hauptrichtung erstreckenden und in der Nebenrichtung nebeneinanderliegenden Zeilen umfaßt, und daß die Belichtungseinrichtung eine Vielzahl von Lichtquellen und eine diese im wesentlichen gleichzeitig ansteuernde Steuerung mit einem Steuerungsspeicher aufweist, welcher so ausgebildet ist, daß aus diesem bereits abgespeicherte Datensätze der Makrozeile, in deren Bereich belichtet wird, ausgelesen werden können, während Datensätze einer weiteren Makrozeile abspeicherbar sind.

Die erfindungsgemäße Vorrichtung dient nicht nur dazu, das vorstehend beschriebene erfindungsgemäße Verfahren durchzuführen, sondern kann auch für ein einfaches Belichten bei der Herstellung von photolithographischen Masken oder großformatigen Baugruppen eingesetzt werden und ist daher nicht darauf beschränkt, daß belichtete Strukturen auf einer Vielzahl von auf mindestens einem Substratkörper angeordneten Baugruppen mittels der Belichtungseinrichtung hergestellt werden sollen.

Der Vorteil der erfindungsgemäßen Vorrichtung ist jedoch nach wie vor der, daß bei der erfindungsgemäßen Vorrichtung die belichtete Struktur effizient hergestellt werden kann.

Weitere vorteilhafte Weiterbildungen einer derartigen Vorrichtung sind Gegenstand der Ansprüche 46 bis 65 und weisen Merkmale der vorstehend beschriebenen vorteilhaften Weiterbildungen des erfindungsgemäßen Verfahrens auf.

Die erfindungsgemäße Vorrichtung läßt sich jedoch auch zum Herstellen von belichteten Strukturen auf einer Vielzahl von mindestens einem Substratkörper angeordneten Baugruppen mittels der Belichtungseinrichtung einsetzen, wobei auf mindestens einem Teil der Baugruppen identische Strukturen hergestellt werden.

Bei dem hierfür vorgesehenen Ausführungsbeispiel der erfindungsgemäßen Vorrichtung gemäß Anspruch 45 ist dabei vorgesehen, dass jede der identischen Strukturen durch Belichten des Substratkörpers im Bereich der jeweils vorgesehenen Baugruppe innerhalb einer Vielzahl von sich in der Hauptrichtung erstreckenden und in der Nebenrichtung nebeneinanderliegenden Makrozeilen hergestellt wird, wobei jede der Makrozeilen eine Vielzahl von sich in der Hauptrichtung erstreckenden und in der Nebenrichtung nebeneinanderliegenden Zeilen umfasst, wobei mit der Belichtungseinrichtung bei einem einmaligen Durchlaufen eines Belichtungsweges alle von diesem Belichtungsweg erfassten und mit identischen Strukturen zu versehenden Baugruppen im Bereich derselben Makrozeile der Vielzahl von Makrozeilen belichtbar sind und wobei die Belichtungseinrichtung eine Vielzahl von Lichtquellen und eine diese im wesentlichen gleichzeitig ansteuernde Steuerung mit einem Steuerungsspeicher aufweist, welcher so ausgebildet ist, dass auf diesem bereits abgespeicherte Datensätze der Makrozeile, in deren Bereich belichtet wird, auslesbar sind, während Datensätze einer weiteren Makrozeile abspeicherbar sind.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: eine schematische Seitenansicht eines ersten Ausführungsbeispiels einer erfindungsgemäßen Belichtungsvorrichtung;
- Fig. 2: eine schematische Seitenansicht ähnlich Fig. 1 einer ersten Variante des ersten Ausführungsbeispiels;
- Fig. 3: eine schematische Seitenansicht ähnlich Fig. 1 einer zweiten Variante des ersten Ausführungsbeispiels;
- Fig. 4: eine Draufsicht auf einen Substratkörper mit den auf diesem vorgesehenen Baugruppen;
- Fig. 5: eine ausschnittsweise Darstellung eines Rasters, in welchem bei der erfindungsgemäßen Belichtungsvorrichtung eine Belichtung durch Pixelflecken erfolgt;
- Fig. 6: eine schematische Darstellung der erfindungsgemäßen Belichtung innerhalb eines Zeilenstreifens durch Ablenkung eines Belichtungsstrahls und damit verbundener Verschiebung des Pixelflecks;
- Fig. 7: eine schematische Darstellung einer Lichtquelle mit Ablenkeinrichtung und Abbildungsoptik zur Verschiebung eines Pixelflecks innerhalb eines Zeilenstreifens;
- Fig. 8: eine schematische Darstellung bei unmaßstäblich gestreckter Hauptrichtung eines Rasters, das sich bei periodischer Bewegung des Belichtungsstrahls über den Zeilenstreifen ergibt;
- Fig. 9: eine schematische Darstellung ähnlich Fig. 7 der Vielzahl von Lichtquellen mit Ablenkeinrichtungen und Abbildungsoptiken zur Erzeugung der Belichtung innerhalb einer Makrozeile;
- Fig. 10: eine schematische Darstellung der Vielzahl von Makrozeilen, die erforderlich ist, um im Bereich einer Baugruppe beliebige Strukturen erzeugen zu können;
- Fig. 11: eine schematische Darstellung zweier Möglichkeiten einer Realisierung eines Belichtungswegs;
- Fig. 12: eine schematische Darstellung zweier weiterer Möglichkeiten der Realisierung eines Belichtungswegs;
- Fig. 13: eine schematische Darstellung einer weiteren Möglichkeit einer Realisierung eines Belichtungswegs;
- Fig. 14: eine schematische Darstellung einer Ausführungsform einer Steuerung bei zu Lichtquellengruppen zusammengefaßten Uchtquellen sowie eine schematische Darstellung einer möglichst kostengünstigen Struktur eines Steuerungsspeichers;
- Fig. 15: eine schematische Darstellung der Positionierung nebeneinanderliegender Gruppenstreifen relativ zueinander;
- Fig. 16: eine schematische Darstellung einer variierenden Zuordnung von Strukturzeilen zu mit der Belichtungseinrichtung belichtbaren Zeilen;
- Fig. 17: eine schematische Darstellung der Zuordnung von Strukturzeilen zu einer Lichtquellengruppe bei tatsächlicher Belichtung im Bereich eines Gruppenstreifens;
- Fig. 18: eine schematische Darstellung eines zweiten Ausführungsbeispiels einer Belichtungsvorrichtung mit mehreren Substratträgern sowie die Relativbewegung der Substratträger zueinander und
- Fig. 19: eine schematische Darstellung ähnlich Fig. 14 eines dritten Ausführungsbeispiels einer Belichtungsvorrichtung.

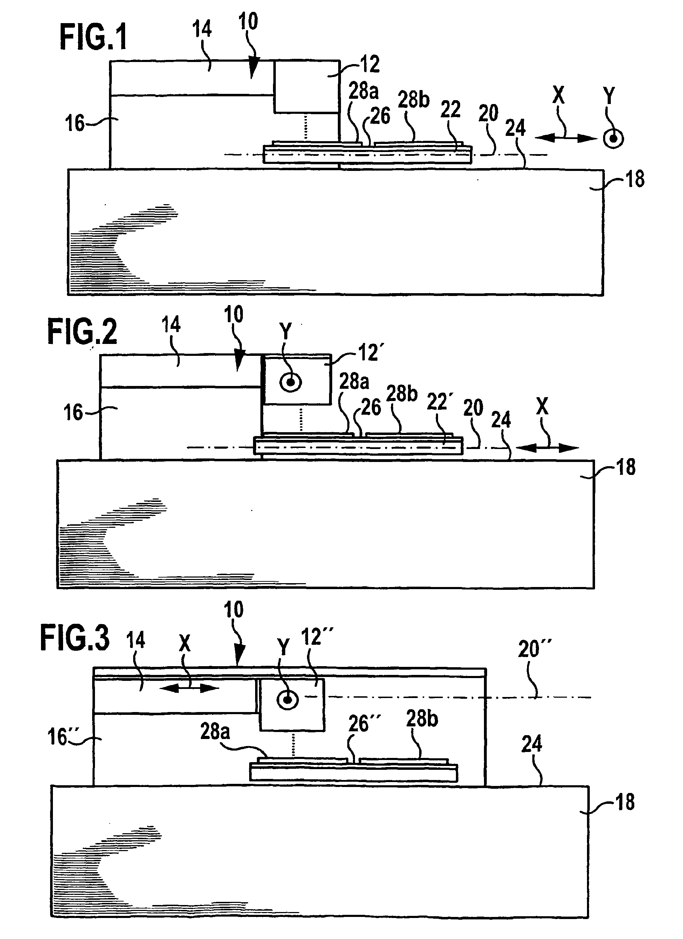

Ein in Fig. 1 dargestelltes Ausführungsbeispiel einer erfindungsgemäßen Vorrichtung zum Belichten von Substratmaterialien umfaßt eine Belichtungseinrichtung 10, welche einen Optikkopf 12 und eine diesem zugeordnete Belichtungssteuerung 14 umfaßt.

Die Belichtungseinrichtung 10 ist dabei beispielsweise mittels eines Brückenkörpers 16 an einem Fundamentkörper 18 abgestützt.

Der Brückenkörper 16 übergreift dabei einen Bewegungsbereich 20, in welchem ein Trägerschlitten 22 relativ zum Fundamentkörper 18 bewegbar ist, wobei der Trägerschlitten 22 auf einer Führungsebene 24 des Fundamentkörpers 18 gleitend, beispielsweise durch Luftpolster geführt ist, wie dies in der deutschen Patentanmeldung DE 10212344 A1 beschrieben ist.

Auf den Trägerschlitten 22 ist ferner noch ein Substratträger 26 angeordnet, auf welchem beispielsweise zwei zur Belichtung vorgesehene Substratkörper 28a, b gehalten sind, die durch die Belichtungseinrichtung 10 belichtet werden sollen.

Hierzu ist der Trägerschlitten 22 durch in Fig. 1 nicht dargestellte Antriebseinheiten für den Trägerschlitten 22 beispielsweise sowohl in einer X-Richtung als Hauptrichtung als auch in einer senkrecht zu dieser verlaufenden Y-Richtung als Nebenrichtung, die beide parallel zur Führungsebene 24 verlaufen, innerhalb des Bewegungsbereichs 20 bewegbar und exakt relativ zur Belichtungseinrichtung 10, insbesondere zum Optikkopf 12 derselben positionierbar.

Der Bewegungsbereich 20 für den Trägerschlitten 22 ist dabei so dimensioniert, daß die Substratkörper 28 auf ihrer gesamten Substratoberfläche 30 belichtet werden können.

Es ist aber auch denkbar, den Trägerschlitten 22' in X-Richtung zu bewegen und den Optikkopf 12' relativ zum Brückenkörper 16 in Y-Richtung zu bewegen, wie in Fig. 2 dargestellt.

Alternativ dazu ist es auch denkbar, den Substratträger 26 stationär anzuordnen und relativ zum Substratträger 26 den Optikkopf 12" relativ zum Brückenkörper 16" in X- und Y-Richtung in einem Bewegungsbereich 20" zu bewegen, um ebenfalls die gesamte Oberfläche 30 des jeweiligen Substrats zu belichten, wie in Fig. 3 dargestellt.

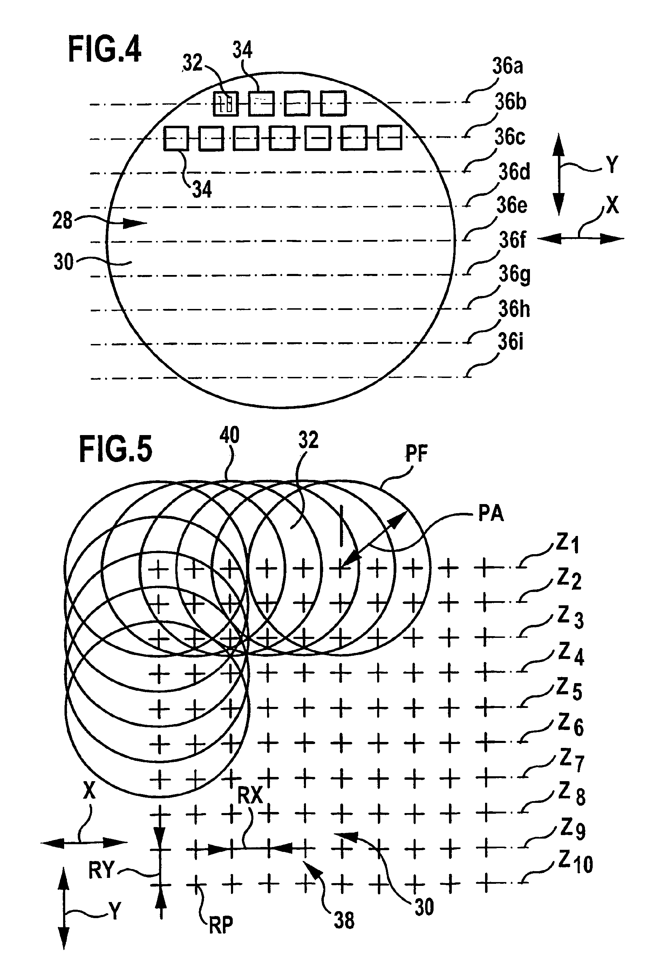

Ein derartiger Substratkörper 28 ist beispielsweise - wie in Fig. 4 dargestellt - ein sogenannter Wafer, wie er in der Halbleitertechnik verwendet wird. Die Belichtung des Wafers erfolgt dazu, um auf diesem definierte Strukturen 32 zu erzeugen, wobei eine oder mehrere derartiger Strukturen 32 dann eine Baugruppe 34, beispielsweise ein elektrisches, ein elektronisches oder ein optisches Bauelement, ergeben.

Dabei erstrecken sich die definierten Strukturen 32 nicht über die gesamte Oberfläche 30 des Substratkörpers 28, sondern es sind in der Regel eine Vielzahl von Baugruppen 34 auf einem derartigen Substratkörper 28 herstellbar, wobei insbesondere alle Baugruppen 34 durch dieselben Strukturen 32 aufgebaut sind.

Zum Herstellen der Baugruppen 34 werden diese vorzugsweise in Reihen 36 auf dem Substratkörper 28 angeordnet, wobei die Reihen 36 sich vorzugsweise parallel zur Hauptrichtung X und senkrecht zur Nebenrichtung Y erstrecken.

Zum Herstellen der definierten Strukturen 32 für die Baugruppen 34 ist es nun erforderlich, jede der Baugruppen 34 durch Belichten mit der Belichtungseinrichtung 10 mit derselben Struktur 32 zu versehen.

Hierzu wird vorzugsweise eine Relativbewegung zwischen der Belichtungseinrichtung 10 und dem Substratträger 26 längs der Hauptrichtung X erzeugt, so, daß vorzugsweise sämtliche Baugruppen 34 einer der Reihen 36 in einem Zug durch die Relativbewegung in der Hauptrichtung X überfahren und dabei belichtet werden und nachfolgend nach einem Versatz in der Nebenrichtung Y ebenfalls wieder ein Überfahren und Belichten sämtlicher Baugruppen 34 einer der Reihen 36 erfolgt.

Das Herstellen der Strukturen erfolgt, wie in Fig. 5 dargestellt, durch Belichten der Oberfläche 30 des Substratkörpers innerhalb des Bereichs der jeweiligen Baugruppen 34 in einem Raster 38, bestehend aus einzelnen Rasterpunkten RP, die einen Rasterabstand RX und RY voneinander aufweisen, wobei dieser Rasterabstand RX, RY beispielsweise in der Größenordnung von 50 Nanometern liegt.

Jeder Rasterpunkt RP stellt ein Zentrum eines Pixelflecks PF dar, welcher ausgehend von dem Zentrum RP eine Pixelausdehnung PA aufweist, die ein Vielfaches des Rasterabstands RX, RY, beispielsweise bis zum ungefähr Fünffachen derselben beträgt.

Werden somit die Pixelflecken PF in dem Raster 38 mit den Rasterpunkten RP als Zentrum nebeneinanderliegender Pixelflecken PF belichtet, so lassen sich zusammenhängende Strukturen 32 erzeugen, bei welchen nebeneinanderliegende Pixelflecken PF mehrfach, beispielsweise fünffach, überlappen, so daß sich relativ geradlinig verlaufende Strukturkanten 40 der belichteten Struktur 32 aus aufeinanderfolgenden Pixelflecken PF bei längs aufeinanderfolgender Rasterpunkte RP sitzenden Pixelflecken PF erzeugen lassen.

Um zum Positionieren der einzelnen Pixelflecken PF in dem Raster 38 die Relativbewegung zwischen dem Substratträger 26 und dem Optikkopf 12 in geeigneter Weise ausnützen zu können, werden die Rasterpunkte RP in Zeilen Z, beispielsweise in Fig. 5 den Zeilen Z1 bis Z10 angeordnet, die parallel zur Hauptrichtung X und senkrecht zur Nebenrichtung Y und somit auch parallel zu den Reihen 36 verlaufen.

Prinzipiell wäre es denkbar, die Belichtungseinrichtung 10 so auszubilden, daß zur Belichtung in jeder der Zeilen Z jederzeit ein eigener Belichtungsstrahl 42 zur Verfügung steht, so daß bei der Relativbewegung zwischen der Belichtungseinrichtung 10 und dem Substratträger 26 in der Hauptrichtung X beispielsweise in allen Zeilen Z zu einem bestimmten Zeitpunkt ein Pixelfleck PF erzeugt werden könnte.

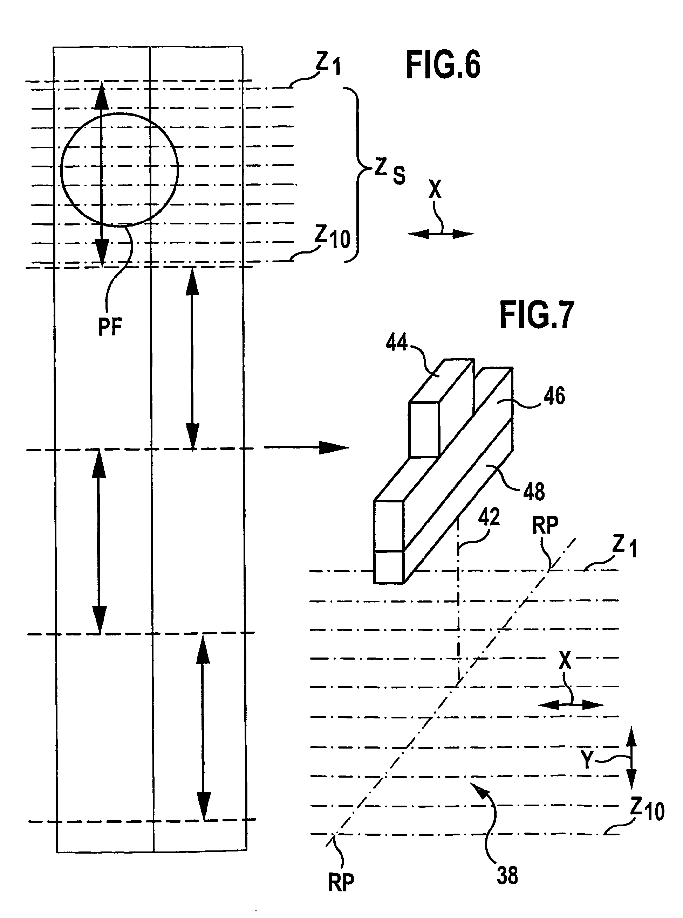

Bei einer besonders günstigen Lösung ist, wie in Fig. 6 dargestellt, vorgesehen, daß der zur Erzeugung eines Pixelflecks PF vorgesehener Belichtungsstrahl 42 in der Nebenrichtung Y so über das Raster 38 bewegbar ist, daß der Pixelfleck PF mit seinem Zentrum beispielsweise auf jeder von 10 Zeilen Z1 bis Z10 positionierbar ist.

Hierzu ist zur Erzeugung des Belichtungsstrahls 42 beispielsweise eine Lichtquelle 44, beispielsweise in Form einer Laserdiode, vorgesehen, deren Lichtstrahl durch eine Ablenkeinheit 46 kombiniert mit einer Mikroskopoptik 48 derart ablenkbar ist, daß der Belichtungsstrahl 42 einen Pixelfleck PF auf der Oberfläche 30 des Substrats erzeugen kann, dessen Zentrum auf jeder der Zeilen Z1 bis Zeile Z10 in dem jeweiligen Rasterpunkt RP positionierbar ist (Fig. 7).

Die von der Lichtquelle 44 mit dem Belichtungsstrahl 42 erfassbaren Zeilen Z1 bis Z10 bilden somit einen Zeilenstreifen ZS der sich, wie in Fig. 6 dargestellt, in der Hauptrichtung X erstreckt.

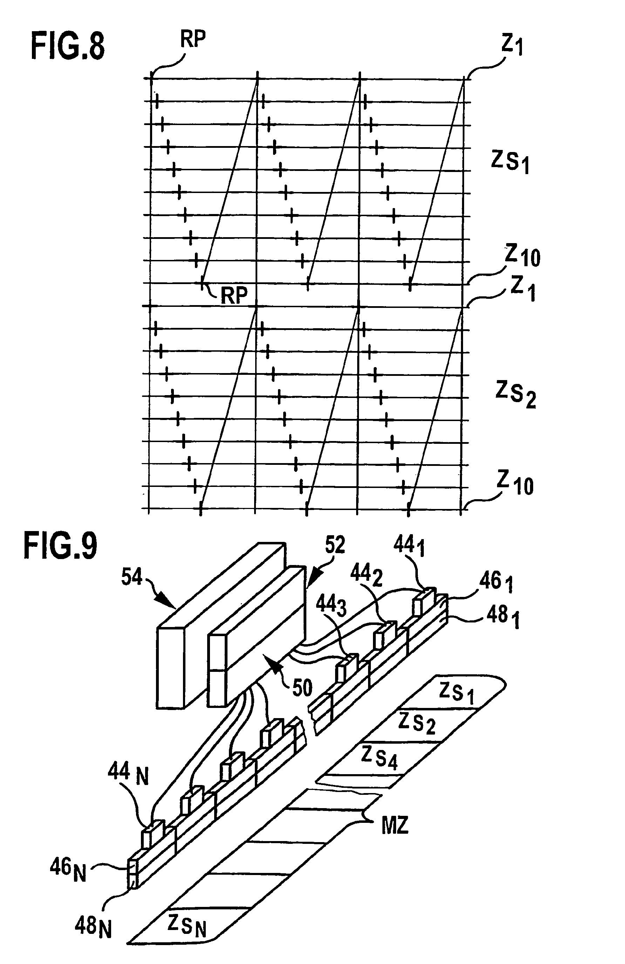

Wie in Fig. 8 mit in Hauptrichtung X vergrößert gezeichnetem Rasterabstand RX im Verhältnis zum Rasterabstand Y dargestellt, wird nun zum Erfassen der Zeilen Z1 bis Z10 eines Zeilenstreifens der Belichtungsstrahl 42 durch die Ablenkeinheit 46 periodisch abgelenkt und schwenkt daher mit festgelegter Zeitkonstante von der Zeile Z1 zur Zeile Z10 und wieder zu dieser zurück, so daß dann, wenn ein Pixelfleck PF mit einem Zentrum auf einem der Zeilen Z1 bis Z10 erzeugt werden soll, zu dem Zeitpunkt eine Belichtung erfolgen muß, zu dem bei der periodischen Schwenkbewegung des Belichtungsstrahls 42 der Belichtungsstrahl 42 mit seinem Zentrum genau auf der ausgewählten Zeile Z des Zeilenstreifens liegt.

Dies führt zwar zu einer geringfügigen Verzerrung des Rasters 38 dahingehend, daß die Rasterpunkte RP in der Zeile Z10 gegenüber den Rasterpunkten RP der Zeile Z1 in Hauptrichtung X um einen Rasterabstand RX/2 verschoben ist, diese Verzerrung ist jedoch aufgrund der Ausdehnung der Pixelflecken PF relativ zu den Rasterabständen RX und RY vernachlässigbar.

Um mit der erfindungsgemäßen Belichtungseinrichtung 10, insbesondere dem Optikkopf 12 nicht nur einen Zeilenstreifen ZS1 sondern beispielsweise N Zeilenstreifen ZS (Fig. 9) belichten zu können, sind eine Vielzahl von Lichtquellen 44₁ bis 44_{N} mit entsprechenden Ablenkeinheiten 46₁ bis 46_{N} und Mikroskopoptiken 48₁ bis 48_{N} in dem Optikkopf 12 vorgesehen, die alle bei einer Relativbewegung zwischen dem Optikkopf 12 und dem Substratträger 26 in der Hauptrichtung X gleichzeitig betreibbar sind.

Um mit der erfindungsgemäßen Belichtungseinrichtung 10 möglichst viele Zeilen Z bei einer einzigen Bewegung in der Hauptrichtung X belichten zu können, wird eine große Zahl N von Lichtquellen 44 mit Ablenkeinheiten 46 und Mikroskopoptiken 48 eingesetzt. Sinnvoll sind dabei Zahlen von einigen hundert Lichtquellen 44, beispielsweise 504 Lichtquellen, die damit in der Lage sind, bei einer Bewegung in der Hauptrichtung X im Bereich von 5040 Zeilen Z eine Belichtung durch einen Pixelfleck PF vorzunehmen.

Zusätzlich sind, um definierte Strukturen 32, insbesondere mit gut abgesetzten Strukturkanten 40 erzeugen zu können, für einen Pixelfleck PF mehrere Graustufen vorgesehen, beispielsweise mehr als 10 Graustufen, vorzugsweise 32 Graustufen pro Pixelfleck PF.

Dies führt bei einer Relativgeschwindigkeit zwischen der Belichtungseinrichtung 10 und dem Substratträger 26 in der Größenordnung von einem Meter pro Sekunde zu Datenmengen und Datenraten, die bei Rasterabständen RX, RY im Bereich um 50 Nanometer in technologische Grenzbereiche der verfügbaren Bauteile führen.

Aus diesem Grund ist es nicht möglich, die zum Schreiben der Zeilen Z innerhalb der Zeilenstreifen ZS1 bis ZSN erforderlichen Daten aus dem Speicher eines übergeordneten Rechners, beispielsweise eines Host-Rechners während des Belichtungsvorgangs bei einer Bewegung in der Hauptrichtung X auszulesen, sondern es ist erforderlich, eine Steuerung 50 für die gleichzeitige Ansteuerung der Lichtquellen 44 vorzusehen, welcher ein eigener Steuerungsspeicher 52 zugeordnet ist, der es der Steuerung 50 erlaubt, die Datensätze für die Zeilensätze ZS1 bis ZSN mit möglichst großer Datenrate auszulesen.

Da eine typische Baugruppe 34, die auf einem Substrat in erfindungsgemäßer Weise durch Belichtung mit einer definierten Struktur 32 versehen werden soll und üblicherweise Dimensionen im Bereich bis zu einigen Zentimetern aufweist, ist auch die mit beispielsweise mehreren hundert Lichtquellen 44 versehene Belichtungseinrichtung 10 nicht in der Lage, im Bereich aller für die Herstellung der Struktur 32 der Baugruppe 34 erforderlichen Zeilen Z eine Belichtung vorzunehmen.

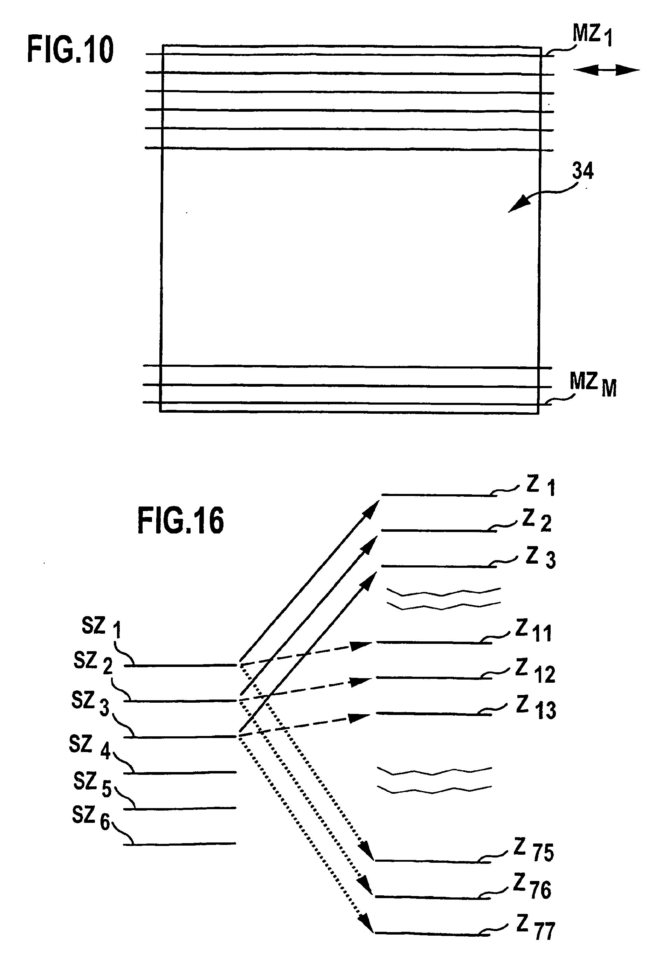

Vielmehr ist es erforderlich, wie in Fig. 10 dargestellt, mit der erfindungsgemäßen Belichtungseinrichtung 10 mehrfach in der Hauptrichtung X, jedoch in der Nebenrichtung Y versetzt die Baugruppe 34 zu überfahren und dabei zu belichten.

Die durch einmaliges Überfahren der Baugruppe 34 in der Hauptrichtung X mit den Lichtquellen 44₁ bis 44_{N} belichtbaren Zeilen, umfaßt durch die Zeilensätze ZS1 bis ZSN, werden dabei als Makrozeile MZ bezeichnet, so daß zum Belichten sämtlicher für die Struktur 32 der Baugruppe 34 erforderlichen Zeilen, wie in Fig. 7 und 8 dargestellt, insgesamt ein Belichten der Baugruppe 34 im Bereich von M nebeneinanderliegenden Makrozeilen MZ erforderlich ist.

Da die die Lichtquellen 44 ansteuernde Steuerung 50 schnellen Zugriff auf den Steuerungsspeicher 52 haben muß, wäre es, wenn insgesamt M Makrozeilen. MZ belichtet werden müssen, erforderlich, in dem Steuerungsspeicher 52 die Datensätze für alle M Makrozeilen MZ der Baugruppe 34 zu speichern.

Dies hätte zur Folge, daß der Steuerungsspeicher 52 sehr groß ausgelegt werden müßte und somit kostenintensiv wäre.

Aus diesem Grund ist vorgesehen, daß der Steuerungsspeicher 52 so ausgebildet ist, daß aus diesem einerseits Datensätze für das Belichten der Zeilen Z durch die Steuerung für die Lichtquellen 44 auslesbar sind, gleichzeitig aber auch Datensätze aus einem Hauptspeicher 54 eines übergeordneten Rechners, beispielsweise des Host-Rechners, einlesbar sind. Damit ist es möglich, während des Belichtens im Bereich einer Makrozeile MZ und somit des Auslesens der Datensätze für dieses Belichten gleichzeitig Datensätze für eine weitere Makrozeile MZ einzulesen.

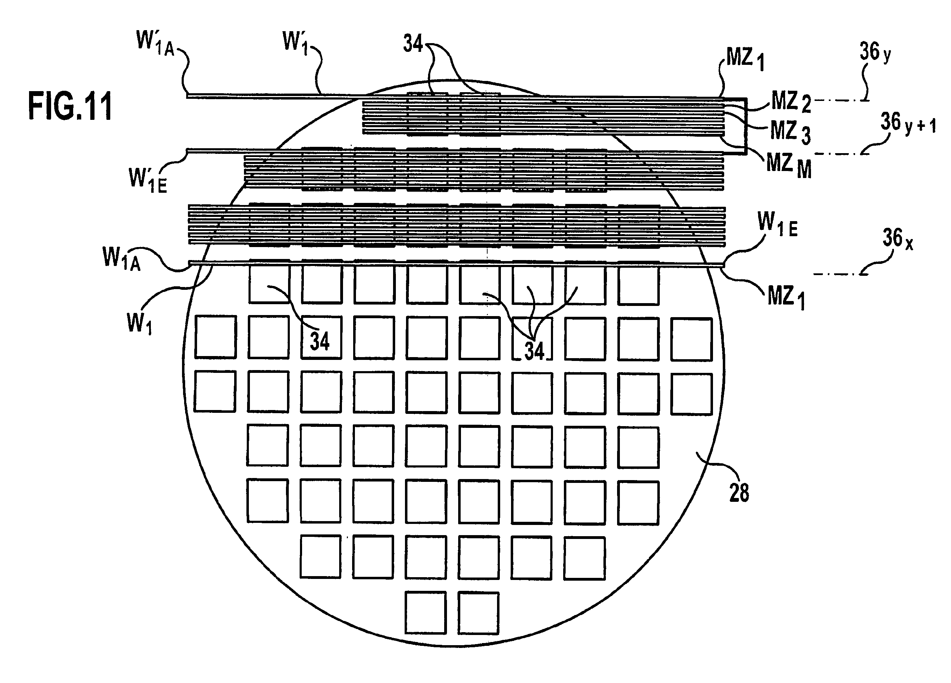

Im Rahmen der erfindungsgemäßen Lösung ist es ferner vorteilhaft, wie in Fig. 11 dargestellt, eine Belichtung im Bereich einer der Makrozeilen MZ nicht nur im Bereich einer einzigen Baugruppe 34 vorzunehmen, sondern im Bereich mehrerer Baugruppen 34, wobei diese Baugruppen 34 längs eines Belichtungswegs W angeordnet sind. Die Größe des Steuerungsspeichers 52 hängt dabei davon ab, wie groß die Zeit ist, die für einen Belichtungsweg W benötigt wird, und wie schnell die Datensätze aus dem Hauptspeicher 54 in dem Steuerungsspeicher 52 abgespeichert werden können.

Im einfachsten Fall wird beispielsweise ein erster Belichtungsweg W1 für eine Belichtung im Bereich der ersten Makrozeile MZ₁, wie in Fig. 11 dargestellt, so gelegt, daß er die Baugruppen 34 erfaßt, die längs einer Reihe 36 angeordnet sind, wobei die Baugruppe 34 die Baugruppen auf einem Substratkörper 28 sind.

Ausgehend von der Zielvorstellung, die M Makrozeilen MZ möglichst ohne Unterbrechung der Bewegung in der Hauptrichtung X zu schreiben, ist der Steuerungsspeicher 52 lediglich so groß zu wählen, daß er etwas mehr als die Hälfte der Makrozeilen MZ speichern kann, wenn der Transfer der Datensätze von dem Hauptspeicher 54 in den Steuerungsspeicher 52 und das Abspeichern derselben so schnell erfolgen kann, daß es während des Durchlaufens des Belichtungswegs W1 von seinem Anfang W1A zu seinem Ende W1E, der alle Baugruppen 34 längs der Reihe 36x erfaßt, möglich ist, ungefähr die Hälfte der Datensätze einer weiteren, noch nicht im Steuerungsspeicher 52 abgelegten Makrozeile MZ zu speichern.

Es ist nämlich dann möglich, zunächst alle im Steuerungsspeicher 52 gespeicherten Makrozeilen durch Fahren entsprechender Belichtungswege W abzuarbeiten, wobei durch das stets erfolgende Abspeichern weiterer Makrozeilen MZ aus dem Hauptspeicher 54 stets ungefähr die Hälfte der bereits abgearbeiteten Makrozeilen MZ neu gespeichert wird, so daß insgesamt eine Größe des Steuerungsspeichers 52 ausreicht, die zwischen 50 und 60% der Datensätze der M Makrozeilen der Baugruppe 34 speichern kann.

Bei den gegebenen Voraussetzungen läßt sich jedoch die Größe des Steuerungsspeichers 52 noch weiter reduzieren, wenn der Belichtungsweg W verlängert wird.

Wird beispielsweise der in Fig.11 dargestellte Belichtungsweg W'1 gefahren, welcher von seinem Anfang W'IA bis zu seinem Ende W'1E die Baugruppen 34 erfaßt, die längs zweier Reihen 36Y und 36Y+1 angeordnet sind, so ist bei derselben Geschwindigkeit in der Hauptrichtung X und derselben Datentransferrate vom Hauptspeicher 54 in den Steuerungsspeicher 52, von welcher vorstehend ausgegangen wurde, es bereits möglich, während des Durchlaufens des Belichtungsweges W'1 die Datensätze einer gesamten weiteren Makrozeile MZ im Steuerungsspeicher 52 abzulegen.

Das heißt, es ist pro Belichtungsweg W', im Verlauf von welchem nur Datensätze einer Makrozeile MZ, beispielsweise der Makrozeile M1 ausgelesen werden, möglich sämtliche Datensätze einer weiteren Makrozeile, beispielsweise der Makrozeile MZ₂, vom Hauptspeicher 54 im Steuerungsspeicher 52 abzuspeichern.

In diesem Fall muß der Steuerungsspeicher 52 lediglich so groß gewählt werden, daß er in der Lage ist, die Datensätze zweier Makrozeilen MZ zu speichern, nämlich die Datensätze, die im Verlauf des Belichtungsweges W' für die jeweilige Makrozeile MZ ausgelesen werden und die Datensätze, die für die als nächstes zu belichtende Makrozeile MZ aus dem Hauptspeicher 54 in den Steuerungsspeicher 52 eingelesen und abgespeichert werden.

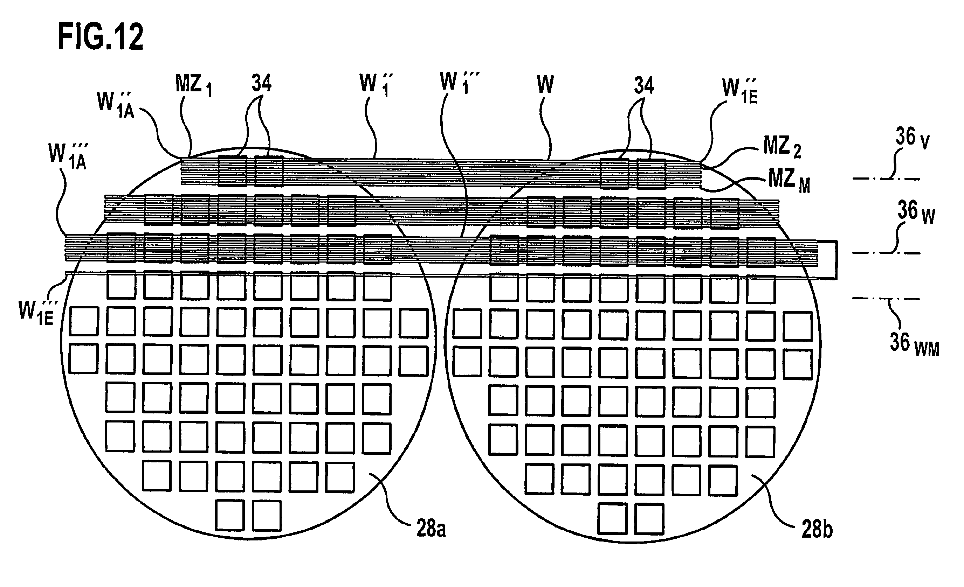

Die Zeit, die für einen Belichtungsweg benötigt wird, läßt sich jedoch aber auch noch weiter dadurch vergrößern, daß auf dem Substratträger 26 nicht nur ein Substratkörper 28, sondern zwei Substratkörper 28a, b angeordnet werden, wobei die herzustellenden definierten Strukturen 32 der Baugruppen 34 identisch sind (Fig. 12).

Ferner sind die Baugruppen 34 auf beiden Substratkörpern 28a, b so anzuordnen, daß sie jeweils in einer gemeinsamen Reihe 36 liegen.

In diesem Fall läßt sich die Zeit, die für das Durchlaufen des jeweiligen Belichtungswegs W, in diesem Fall des Belichtungswegs W1" benötigt wird, dadurch vergrößern, daß der Belichtungsweg W1" die Baugruppen 34 erfaßt, die längs der Reihe 36 auf beiden Substratkörpern 28a, b angeordnet sind.

Die Zeit für das Durchlaufen des Belichtungswegs W1" von seinem Anfang W1"A bis zu seinem Ende W1"E ist zwangsläufig größer als die Zeit für das Durchlaufen des Belichtungswegs W1, dargestellt in Fig. 12 und liegt vorzugsweise in der Größenordnung der Zeit für das Durchlaufen des Belichtungswegs W1", dargestellt in Fig. 12, allerdings mit dem Vorteil, daß zum Durchlaufen des Belichtungswegs W1" lediglich eine geradlinige Bewegung in der Hauptrichtung X erforderlich ist und keine Bewegung in der Nebenrichtung Y, so daß beispielsweise für die gegenläufige Bewegung in der Hauptrichtung X bereits das Schreiben einer weiteren Makrozeile MZ vorgesehen werden kann.

Erfolgt jedoch die Bewegung in der Hauptrichtung X sehr schnell oder ist die Datentransferrate für das Transferieren und Abspeichern der Datensätze einer Makrozeile MZ vom Hauptspeicher 54 in den Steuerungsspeicher 52 gering, so läßt sich eine weitere Vergrößerung der Zeit für das Durchlaufen des Belichtungswegs W dann erreichen, wenn, wie in Fig. 12, bei den Baugruppen 34 zweier Substratkörpern 28a, b eine Belichtung im Bereich einer Makrozeile MZ längs des Belichtungswegs W1"' erfolgt, der die Baugruppen 34 von zwei, beispielsweise nebeneinanderliegenden Reihen 36W und 36W+1 erfaßt und somit mindestens doppelt so lang wie der Belichtungsweg W" ist.

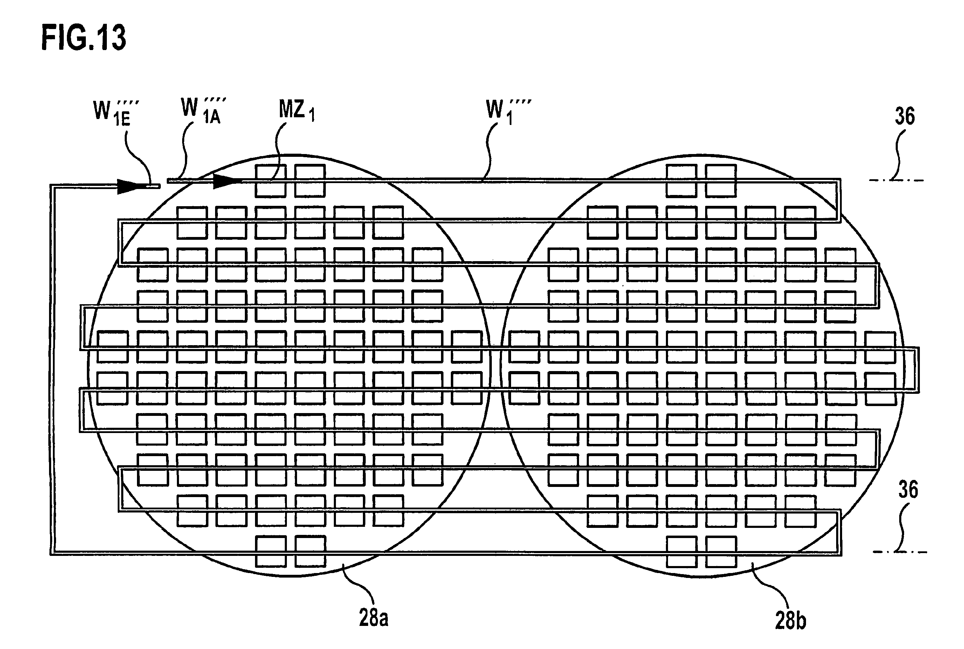

Ist die Bewegung in der Hauptrichtung X sehr schnell und die Datenraten für den Transfer der Datensätze von dem Hauptspeicher 54 in den Steuerungsspeicher sehr gering, so läßt sich im Extremfall, wie in Fig. 13 dargestellt, ein Belichtungsweg W1"" wählen, welcher vorsieht, daß dieselbe Makrozeile MZ, beispielsweise die Makrozeile MZ₁ auf allen Baugruppen 34 von allen Substratkörpern 28a, b des Substratträgers 26 von dem Belichtungsweg W1"" erfaßt wird.

Bei beispielsweise zwei auf dem Substratträger 26 vorhandenen Substratkörpern 28a, b ist dies die maximal mögliche Länge eines möglichen Belichtungswegs W, der somit auch die maximal mögliche Zeit zur Verfügung stellt, um die Datensätze einer weiteren Makrozeile MZ von dem Hauptspeicher 54 in den Steuerungsspeicher 52 zu transferieren und dort abzuspeichern.

Die Verwendung einer Vielzahl, beispielsweise mehrerer hundert von Lichtquellen 44 und die gleichzeitige Ansteuerung derselben mit der Steuerung 50 führt ebenfalls an die Grenze der für eine derartige Steuerung 50 und einen derartigen Steuerungsspeicher 52 einsetzbaren Bauteile.

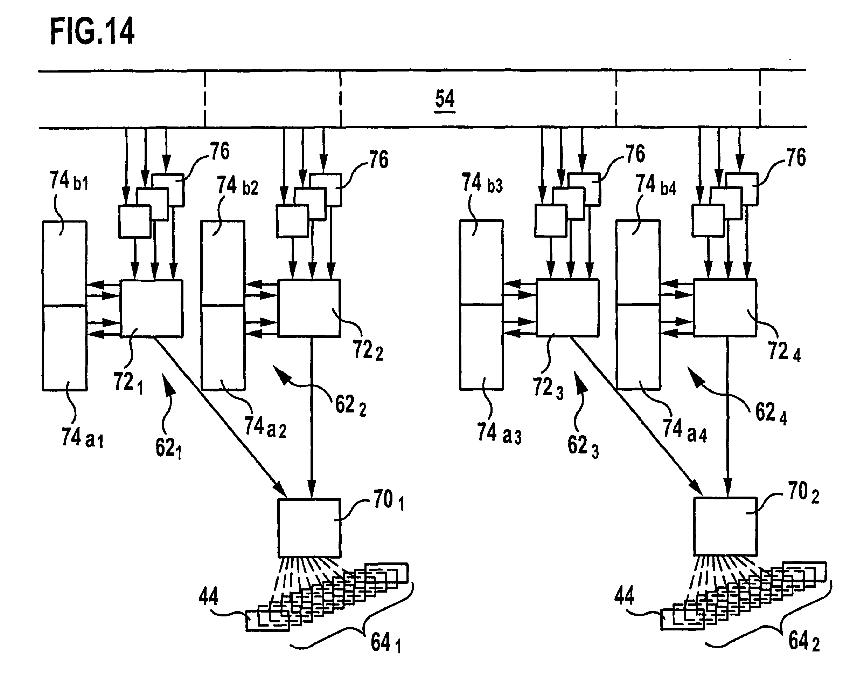

Aus diesem Grund wird die Gesamtheit der Lichtquellen 44 in Lichtquellengruppen 64 aufgeteilt, wobei jede Lichtquellengruppe 64 ungefähr 20 bis 40 Lichtquellen, vorzugsweise 25 bis 35 Lichtquellen umfaßt. Im dargestellten Ausführungsbeispiel umfaßt jede Lichtquellengruppe 28 Lichtquellen 44 (Fig. 14).

Bei einer derartigen Struktur der Lichtquellengruppen 64 ist die Steuerung 50 aufgeteilt in einzelne Gruppensteuerungen 70, wobei jede Gruppensteuerung 70 unabhängig von der anderen Gruppensteuerung arbeitet, um die dieser zugeordnete Lichtquellengruppe 64, vorzugsweise Treiber der einzelnen Lichtquellen 44 der Lichtquellengruppe 64, gleichzeitig anzusteuern.

Ferner ist auch der Steuerungsspeicher 52 aufgeteilt. Vorzugsweise ist der Steuerungsspeicher 52 gebildet aus einer Vielzahl von Steuerungsspeichereinheiten 62, wobei jede Steuerungsspeichereinheit 62 einen Steuerungsmodul 72 aufweist, welcher mit mehreren Steuerungsspeichermodulen 74, vorzugsweise ausgebildet als RAM, zusammenwirkt. Beispielsweise wirkt jeder Steuerungsmodul 72 mit zwei Steuerungsspeichermodulen 74a, b oder einer noch größeren Zahl von Steuerungsspeichermodulen 74 zusammen (Fig. 14).

Der Steuerungsmodul 72 selbst ist vorzugsweise als sogenannter RAM FPGA ausgebildet und dient dazu, einerseits aus dem jeweiligen Steuerungsspeichermodul 74 Datensätze auszulesen und gleichzeitig aber auch Datensätze in diesen einzulesen.

Der Transfer der Datensätze aus dem Hauptspeicher 54 erfolgt durch sogenannte Schnittstellenmodule 76, insbesondere USB's, welche zwischen dem Hauptspeicher 54 und dem jeweiligen Steuerungsmodul 72 zum parallelen Übertragen der Datensätze aus dem Hauptspeicher 54 vorgesehen sind, wobei der Steuerungsmodul 72 dann seinerseits wiederum diese Datensätze in den Steuerungsspeichermodulen 74 abspeichert.

Jeder der unabhängig voneinander arbeitenden Gruppensteuerungen 70 ist vorzugsweise nicht nur einer Steuerungsspeichereinheit 62 zugeordnet, sondern es sind mehrere Steuerungsspeichereinheiten 62 pro Gruppensteuerung 70 vorgesehen. Im in Fig. 14 dargestellten Fall sind jeder der Gruppensteuerungen 70₁ und 70₂ jeweils zwei Steuerungsspeichereinheiten 62₁und 62₂ bzw. 62₃ und 62₄ zugeordnet.

Jede der Lichtquellengruppen 64 ist somit in der Lage, in einem Teil der Vielzahl V von Zeilen Z einer Makrozeile MZ eine Belichtung durchzuführen.

Da - wie bereits dargelegt - jeder Lichtquelle 44 vorzugsweise ein Zeilenstreifen ZS umfassend mehrere Zeilen Z zugeordnet ist, entspricht die Zahl T der Zeilen Z, in welcher mittels einer Lichtquellengruppe 64 eine Belichtung durchführbar ist, der Zahl der Zeilen Z pro Zeilenstreifen ZS multipliziert mit der Zahl Q der Lichtquellen 44 pro Lichtquellengruppe 64.

Die Zahl T von Zeilen Z, die somit einer Lichtquellengruppe 64 zugeordnet ist, bildet insgesamt einen sich in der Hauptrichtung X erstreckenden Gruppenstreifen GS.

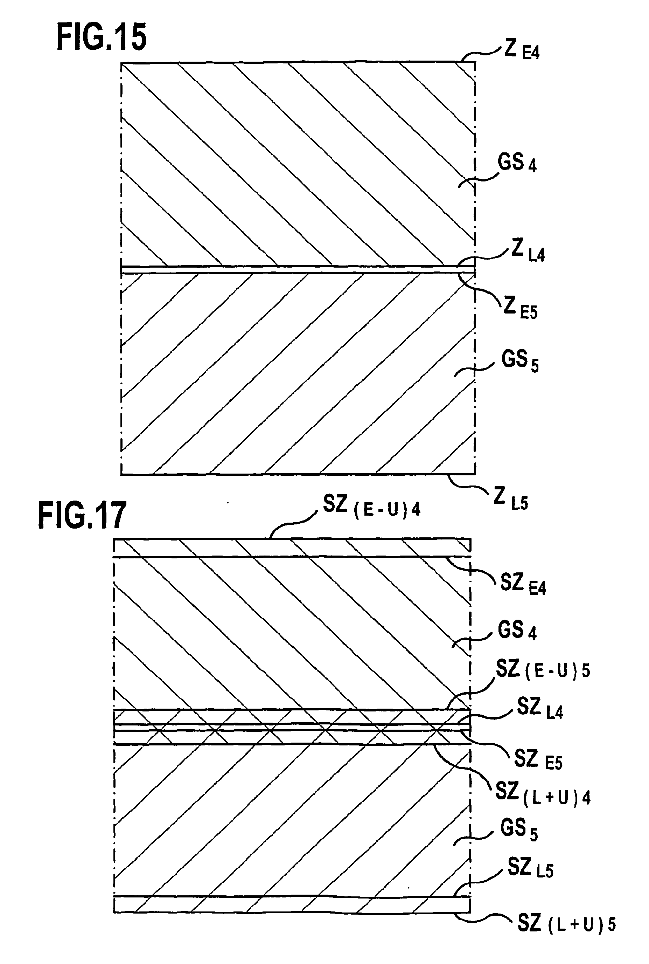

So lange die für die definierte Struktur vorgesehenen Strukturzeilen eindeutig den Zeilen Z zugeordnet bleiben, so lange können die Gruppenstreifen GS so angeordnet werden, daß bei aneinander angrenzenden Gruppenstreifen, beispielsweise den Gruppenstreifen GS₄ und GS₅ in Fig. 15, das die erste Zeile ZE₅ des auf den Gruppenstreifen GS₄ folgenden Gruppenstreifens GS₅ im Rasterabstand RY von der letzten Zeile ZL₄ des Gruppenstreifens GS₄ angeordnet ist.

Bei der Relativpositionierung der Belichtungseinrichtung 10, insbesondere des Optikkopfes 12 zu den Substraten 28a, b auf dem Substratträger 26 ist jedoch ein Positionierfehler in der Nebenrichtung Y möglich, der insbesondere dann korrigiert werden muß, wenn mehrere definierte Strukturen 32 übereinander gelegt werden, die relativ zueinander exakt positioniert sein sollen.

Ein derartiger Positionierfehler in der Nebenrichtung Y kann zwar durch den Antrieb für die Positionierung des Trägerschlittens 32 ausgeglichen werden.

Eine besonders vorteilhafte Ausführungsform sieht jedoch vor, daß mit dem Trägerschlitten 22 eine Grobpositionierung in der Nebenrichtung Y erfolgt, während eine eine Parallelverschiebung in Y-Richtung umfassende Feinpositionierung der Strukturen 32 relativ zueinander durch unterschiedliche Zuordnung der Datensätze von die Struktur 32 definierenden Strukturzeilen SZ zu den einzelnen Zeilen Z erfolgt, in welchen belichtbar ist.

Das heißt, daß die Gesamtzahl G von Zeilen Z, in welchen ein Belichten des Substrats 28 im Bereich der jeweiligen Baugruppe 34 mit der Belichtungseinrichtung 10 möglich ist, größer ist als die Gesamtzahl S von Strukturzeilen SZ, im Bereich von welchen eine Belichtung erforderlich ist, um die definierte Struktur 32 zu erzeugen.

Das heißt, daß eine Zuordnung der Strukturzeilen SZ zu den Zeilen Z, in welchen eine Belichtung des Substratkörpers 28 möglich ist, variabel gehalten werden kann.

Beispielsweise ist es denkbar, die erste Strukturzeile SZ₁ der ersten Zeile Z₁ der Makrozeile MZ, in welcher eine Belichtung durchzuführen ist, zuzuordnen, wie in Fig. 16 durch die durchgezogen gezeichneten Pfeile dargestellt ist. Die Zuordnung der nächstfolgenden Strukturzeilen SZ₂ und folgende erfolgt dabei zu den nächstfolgenden Zeilen Z₂ und folgende.

Es ist aber auch denkbar, mittels der Steuerung 50 die erste Strukturzeile SZ₁ beispielsweise der elften Zeile Z₁₁ der Makrozeile MZ, in welcher eine Belichtung durchführbar ist, zuzuordnen, wie in Fig. 16 durch gestrichelte Pfeile dargestellt, oder, wie in Fig. 14 durch gepunktete Pfeile dargestellt, die erste Strukturzeile SZ₁ der 75. Zeile Z₇₅ der Makrozeile MZ, in welcher eine Belichtung durchführbar ist, zuzuordnen.

Die variable Zuordnung der Strukturzeilen SZ zu tatsächlich zu schreibenden Zeilen Z durch die Steuerung hat - wenn lediglich die Makrozeilen betrachtet werden - die Folge, daß die Zahl der dem Steuerungsspeicher 52 zu speichernden Datensätze größer wird, da für jede zwischen der ersten und letzten Makrozeile MZ1 und MZM liegende Makrozeile MZ nicht nur die Datensätze für die Gesamtzahl V von tatsächlich zu schreibenden Zeilen Z der Makrozeile gespeichert werden müssen, sondern dazu noch die beiderseits der jeweiligen Makrozeile MZ angrenzende Zahl U von Zeilen, wobei die Zahl U von Zeilen der halben maximal möglichen Verschiebung der Zuordnung von Strukturzeilen SZ und Zeilen entspricht, die von der Steuerung 50 noch beim Ansteuern der Lichtquellen 44 doch geändert werden kann.

Erfolgt eine derartige Veränderung der Zuordnung der Strukturzeilen SZ relativ zu den Zeilen Z, in welche eine Belichtung tatsächlich durchführbar ist, so hat dies zur Folge, daß beim Vorsehen von Lichtquellengruppen 64 und unabhängig voneinander arbeitenden, diesen Lichtquellengruppen 64 zugeordneten Gruppensteuerungen 70 die Möglichkeit der Veränderung der Zuordnung bei jedem der Gruppenstreifen GS, der von einer Lichtquellengruppe 64 erzeugt wird, zu berücksichtigen ist. Das heißt, daß jeder der Gruppensteuerungen 70, wie in Fig. 17 dargestellt, nicht nur von der Gesamtzahl der Strukturzeilen SZ eine Teilmenge von Datensätzen zur Verfügung gestellt werden darf, die genau einer Zahl T von Zeilen Z entspricht, in denen tatsächlich belichtet werden kann, sondern eine Teilmenge von Datensätzen der Gesamtzahl von Strukturzeilen zur Verfügung gestellt werden muß, die gegenüber der Zahl der Zeilen Z eines Gruppenstreifens GS beiderseits des Gruppenstreifens GS um eine Zahl U vergrößert ist.

So sind beispielsweise zum Belichten innerhalb des Gruppenstreifens GS₄ nicht nur die Datensätze der Strukturzeilen SZE1 bis SZL1 zur Verfügung zu stellen, die zum Belichten innerhalb eines Bereichs von T möglichen Zeilen Z des Gruppenstreifens GS₄ erforderlich sind, sondern Datensätze von der Strukturzeile SZ_{(E-U)4} bis zur Strukturzeile SZ_{(L+U)4}, so daß mit der Gruppensteuerung 70 noch die Möglichkeit besteht, innerhalb der Strukturzeilen SZ_{(E-U)4} und SZ_{(L-U)4} zu belichten, die in diesem Fall den Zeilen Z_{E1} bis Z_{L4} zugeordnet würden oder die Zuordnung soweit zu verschieben, daß im Bereich der Strukturzeilen SZ_{(E+U)4} und SZ _{(L+U)4} eine Belichtung erfolgt, die in diesem Fall den Zeilen Z_{E4} bis Z_{L4} des Gruppenstreifen GS₄ zugeordnet würden.

Damit wird die Datenmenge, die für jede der Gruppensteuerungen 70 in den dieser zugeordneten Steuerungsspeichermodulen 74 zu speichern ist, insgesamt vergrößert.

Ferner ist in Fig. 17 dargestellt, daß sich die der den Gruppenstreifen GS₄ erzeugenden Lichtquellengruppen 64 zur Verfügung gestellte Teilmenge von Strukturzeilen SZ_{(E-U)4} bis SZ_{(L+U)4} und die der den Gruppenstreifen GS₅ erzeugenden Lichtquellengruppe 64 zur Verfügung gestellte Teilmenge von Strukturzeilen SZ_{(E-U)5} bis SZ_{(L+U)5} in einem Überlappungsbereich UB überlappen, und somit in diesen für jede der Lichtquellengruppen 64 dieselben Strukturzeilen SZ_{(E-U)5} bis SZ_{(L+U)4} zur Verfügung gestellt werden müssen.

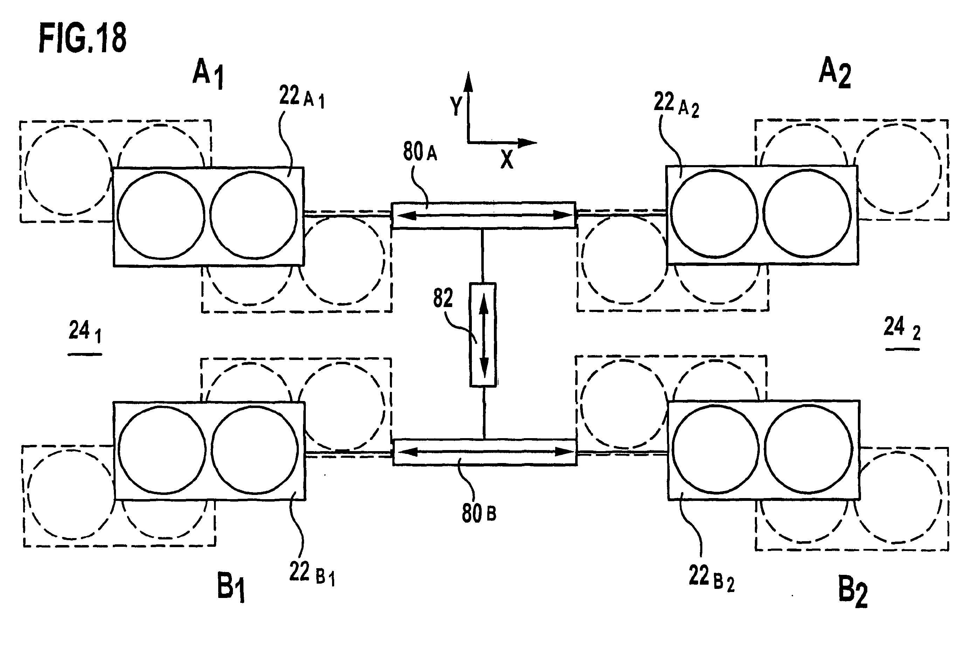

Bei einem zweiten Ausführungsbeispiel einer erfindungsgemäßen Vorrichtung - dargestellt in Fig. 18 - zum Belichten von Substraten, insbesondere entsprechend einem der vorstehend beschriebenen Verfahren, sind, wie in Fig. 18 dargestellt, insgesamt vier Vorrichtungen A₁, A₂, B₁, B₂ zum Belichten von Substratkörpern 28 vorgesehen, wobei aus Gründen der Vereinfachung lediglich deren Trägerschlitten 22A₁, 22A₂, 22B₁, 22B₂ dargestellt sind und die Belichtungseinrichtung 10 der einzelnen Vorrichtungen nicht dargestellt ist.

Beispielsweise sind die Trägerschlitten 22A₁ und 22B₁ auf einer Führungsebene 24₁ geführt, während die Trägerschlitten 22A₂ und 22B₂ auf einer eigenen Führungsebene 24₂ geführt sind.

Ferner ist für die Trägerschlitten 22A₁ und 22A2 eine gemeinsame Antriebseinrichtung 80A und für die Trägerschlitten 22B₁ und 22B₂ eine gemeinsame Antriebseinrichtung 80B vorgesehen, die jeweils dazu dient, die Trägerschlitten 22A₁ und 22A₂ bzw. 22B₁ und 22B₂ in der Hauptrichtung X zu bewegen, und zwar so, daß die Bewegung entgegengesetzt, das heißt mit einer Phasenverschiebung von 180°, zueinander erfolgt, das heißt beide Trägerschlitten 22A₁ und 22A₂ bzw. 22B₁ und 22B₂ werden von der Antriebseinrichtung 80A bzw. 80B entweder aufeinander zu oder voneinander weg bewegt.

Darüber hinaus sind die Antriebseinrichtungen 80A und 80B ihrerseits relativ zueinander bewegbar, und zwar durch eine gemeinsame Antriebseinrichtung 82 für eine Bewegung in der Nebenrichtung Y.

Durch die gemeinsame Antriebseinrichtung 82 sind die Paare von Trägerschlitten einerseits gebildet durch die Trägerschlitten 22A₁ und 22A₂ und andererseits gebildet durch die Trägerschlitten 22B₁ und 22B₂ paarweise in der Nebenrichtung bewegbar und zwar ebenfalls aufeinander zu oder voneinander weg. Das heißt, daß entweder die Trägerschlitten 22A1 und 22B₁ bzw. 22A₂ und 22B₂ aufeinander zu bewegt werden oder voneinander weg.

Durch derart arbeitende Antriebseinrichtungen 80A und 80B sowie 82 ist die Möglichkeit gegeben, möglichst weitgehend Trägheitskräfte beim Beschleunigen der Trägerschlitten 22A₁, 22A₂, 22B₁ und 22B₂ zu kompensieren, wobei dies vorzugsweise voraussetzt, daß die Substratkörper 28 auf allen diesen Trägerschlitten 22A₁, 22A₂, 22B₁, und 22B₂ mit dieselben Strukturen 32 aufweisenden Baugruppen 34 versehen werden sollen.

Im übrigen ist das zweite Ausführungsbeispiel in gleicher Weise ausgebildet und arbeitet auch in gleicher Weise wie das erste Ausführungsbeispiel der erfindungsgemäßen Vorrichtung zum Belichten von Substraten.

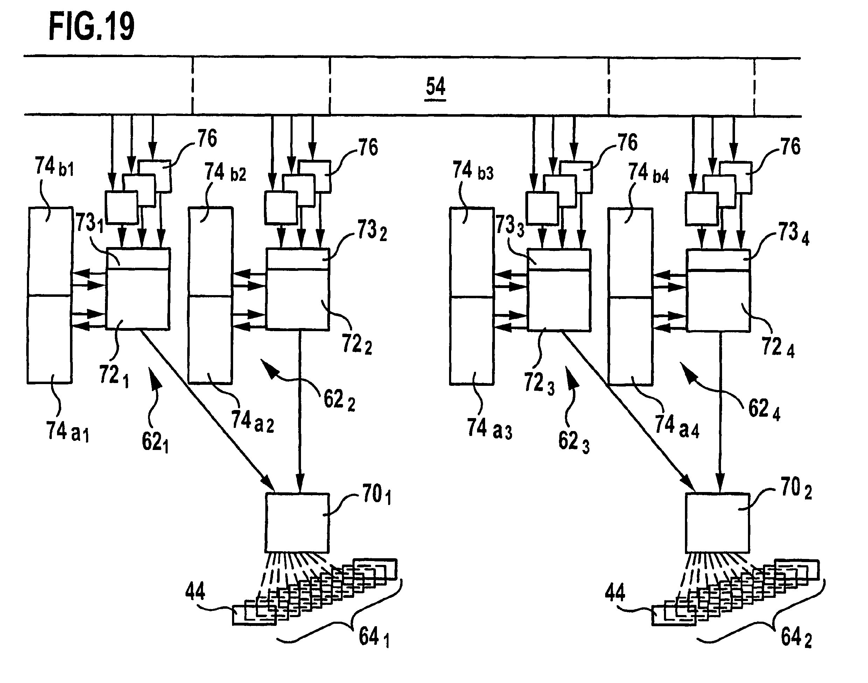

Bei einem dritten Ausführungsbeispiel einer erfindungsgemäßen Belichtungseinrichtung, dargestellt in Fig. 19, sind diejenigen Elemente, die mit dem ersten Ausführungsbeispiel identisch sind, mit denselben Bezugszeichen versehen, so daß hinsichtlich der Beschreibung derselben vollinhaltlich auf die Ausführungen zum ersten Ausführungsbeispiel, insbesondere im Zusammenhang mit Fig. 14, Bezug genommen wird.

Im Gegensatz zum ersten Ausführungsbeispiel, in welchem nicht näher auf die Abspeicherung der Datensätze im Hauptspeicher 54 und in den Steuerungsspeichereinheiten 62 eingegangen wurde, ist beim dritten Ausführungsbeispiel vorgesehen, daß die Datensätze in dem Hauptspeicher 54 im Vektordatenformat abgespeichert sind und die Datenübertragung über die Schnittstellenmodule 56 ebenfalls im Vektordatenformat erfolgt.

Unmittelbar vor den Steuerungsmodulen 72 sind jedoch Wandler 73 vorgesehen, welche das Vektordatenformat in ein Pixeldatenformat wandeln, in welchem dann die Datensätze über das jeweilige Steuerungsmodul 72 in der jeweiligen Steuerungsspeichereinheit 62 abgespeichert werden, so daß die Datensätze dann in Pixelformat von den einzelnen Gruppensteuerungen 70 der Steuerung 50 ausgelesen und zur Ansteuerung der Lichtquellen 44 eingesetzt werden können.

Im übrigen entspricht das dritte Ausführungsbeispiel der erfindungsgemäßen Belichtungsvorrichtung dem ersten Ausführungsbeispiel, so das hinsichtlich der übrigen Aspekte auch auf die Ausführungen zum ersten Ausführungsbeispiel vollinhaltlich Bezug genommen werden kann.

## Patentansprüche

1. Verfahren zum Herstellen von belichteten Strukturen (32) auf einer Vielzahl von auf mindestens einem Substratkörper (28) angeordneten Baugruppen (34) mittels einer Belichtungseinrichtung (10), bei welcher mindestens ein auf einem Substratträger (26) angeordneter Substratkörper (28) und die Belichtungseinrichtung (10) relativ zueinander in einer Hauptrichtung (X) und quer zu dieser in einer Nebenrichtung (Y) bewegt werden, wobei auf mindestens einem Teil der Baugruppen (34) identische Strukturen hergestellt werden, wobei jede der identischen Strukturen (32) durch Belichten des Substratkörpers (28) im Bereich der jeweils vorgesehenen Baugruppe (34) innerhalb einer Vielzahl (M) von sich in der Hauptrichtung (X) erstreckenden und in der Nebenrichtung (Y) nebeneinanderliegenden Makrozeilen (MZ) hergestellt wird, wobei jede der Makrozeilen (MZ) eine Vielzahl (V) von sich in der Hauptrichtung (X) erstreckenden und in der Nebenrichtung (Y) nebeneinanderliegenden Zeilen (Z) umfaßt,
**dadurch gekennzeichnet, daß** mit der Belichtungseinrichtung (10) bei einem einmaligen Durchlaufen eines Belichtungsweges (W) alle von diesem Belichtungsweg (W) erfaßten und mit identischen Strukturen zu versehenden Baugruppen (34) im Bereich derselben Makrozeile (MZ) der Vielzahl (M) Makrozeilen (MZ) belichtet werden, daß die Belichtungseinrichtung (10) eine Vielzahl (N) von Lichtquellen (44) und eine diese im wesentlichen gleichzeitig ansteuernde Steuerung (50) mit einem Steuerungsspeicher (52) aufweist, welcher so aufgebaut ist, daß aus diesem Steuerungsspeicher (52) bereits abgespeicherte Datensätze der Makrozeile (MZ), in deren Bereich belichtet wird, ausgelesen werden können, während Datensätze einer weiteren Makrozeile (MZ) abgespeichert werden.

2. Verfahren nach Anspruch 1, **dadurch gekennzeichnet, daß** der Belichtungsweg (W) mindestens so lange gewählt wird, daß die Zeit zum Durchlaufen desselben mindestens der Zeit entspricht, die für ein Abspeichern von mindestens der Hälfte der Datensätze der weiteren Makrozeile (MZ) in dem Steuerungsspeicher (52) benötigt wird.

3. Verfahren nach Anspruch 2, **dadurch gekennzeichnet, daß** der Belichtungsweg (W) mindestens so lange gewählt wird, daß die Zeit zum Durchlaufen desselben mindestens der Zeit entspricht, die für ein Abspeichern von mindestens zwei Drittel der Datensätze der weiteren Makrozeile (MZ) in dem Steuerungsspeicher (52) benötigt wird.

4. Verfahren nach einem der voranstehenden Ansprüche, **dadurch gekennzeichnet, daß** der Belichtungsweg (W) mindestens so lange gewählt wird, daß die Zeit zum Durchlaufen desselben mindestens der Zeit entspricht, die für ein Abspeichern der Datensätze der weiteren Makrozeile (MZ) in dem Steuerungsspeicher (52) benötigt wird.

5. Verfahren nach einem der voranstehenden Ansprüche, **dadurch gekennzeichnet, daß** der Belichtungsweg (W) sich über nur einen Substratkörper (28) erstreckt.

6. Verfahren nach einem der voranstehenden Ansprüche, **dadurch gekennzeichnet, daß** der Belichtungsweg (W) sich über mehrere Substratkörper (28) erstreckt.

7. Verfahren nach einem der voranstehenden Ansprüche, **dadurch gekennzeichnet, daß** der Belichtungsweg (W) in der Hauptrichtung (X) geradlinig verläuft.

8. Verfahren nach einem der voranstehenden Ansprüche, **dadurch gekennzeichnet, daß** der Belichtungsweg (W) in der Hauptrichtung (X) und der Nebenrichtung (Y) verläuft.

9. Verfahren nach Anspruch 7, **dadurch gekennzeichnet, daß** der Belichtungsweg (W) ausschließlich und geradlinig in der Hauptrichtung (X) verläuft.

10. Verfahren nach einem der Ansprüche 1 bis 8, **dadurch gekennzeichnet, daß** der Belichtungsweg (W) mäanderförmig verläuft.

11. Verfahren nach einem der voranstehenden Ansprüche, **dadurch gekennzeichnet, daß** die Baugruppen (34) in sich parallel zur Hauptrichtung (X) erstreckenden Reihen (36) auf den Substratkörpern (28) angeordnet sind.

12. Verfahren nach Anspruch 11, **dadurch gekennzeichnet, daß** der Belichtungsweg (W) mindestens eine Reihe (36) von Baugruppen (34) erfaßt.

13. Verfahren nach Anspruch 12, **dadurch gekennzeichnet, daß** der Belichtungsweg (W) alle in einer in der Hauptrichtung (X) verlaufenden Reihe (36) angeordneten Baugruppen (34) auf einem Substratträger (26) erfaßt.

14. Verfahren nach Anspruch 12 oder 13, **dadurch gekennzeichnet, daß** der Belichtungsweg (W) mehrere Reihen (36) von Baugruppen (34) erfaßt

15. Verfahren nach Anspruch 14, **dadurch gekennzeichnet daß** die mehreren Reihen (36) von Baugruppen (34) nebeneinanderliegen.

16. Verfahren nach einem der Ansprüche 12 bis 15, **dadurch gekennzeichnet, daß** der Belichtungsweg (W) in der Hauptrichtung (X) eine Reihe (36) von Baugruppen (34) erfaßt und dann quer zur Hauptrichtung (X) auf eine weitere Reihe (36) von Baugruppen (34) wechselt und diese erfaßt.

17. Verfahren nach Anspruch 16, **dadurch gekennzeichnet, daß** der Belichtungsweg (W) die weitere Reihe (36) in umgekehrter Laufrichtung durchläuft als die eine Reihe (36).

18. Verfahren nach Anspruch 16 oder 17, **dadurch gekennzeichnet, daß** die weitere Reihe (36) die in der Nebenrichtung (Y) auf die eine Reihe (36) nächstfolgende Reihen (36) ist.

19. Verfahren nach einem der voranstehenden Ansprüche, **dadurch gekennzeichnet, daß** zum Belichten der Vielzahl (V) von Zeilen (Z) einer Makrozeile (MZ) die gesamte Vielzahl (N) von Lichtquellen (44) der Belichtungseinrichtung (10) vorgesehen ist.

20. Verfahren nach einem der voranstehenden Ansprüche, **dadurch gekennzeichnet, daß** der Steuerungsspeicher (52) über eine Schnittstelle (76) mit mindestens einem Hauptspeicher (54), der mindestens die Datensätze der Vielzahl (M) von Makrozeilen (MZ) einer Baugruppe (34) speichert, kommuniziert.

21. Verfahren nach einem der voranstehenden Ansprüche, **dadurch gekennzeichnet, daß** der Steuerungsspeicher (52) mehrere Steuerungsspeichermodule (74) umfaßt und daß die Steuerung (50) mit den mehreren Steuerungsspeichermodulen (74) des Steuerungsspeichers (52) gleichzeitig kommuniziert.

22. Verfahren nach Anspruch 21, **dadurch gekennzeichnet, daß** mehrere Steuerungsspeichermodule (74) mittels eines Steuerungsmoduls (72) zu einer Steuerungsspeichereinheit (62) zusammengefaßt sind und über diese mit der Steuerung (50) kommunizieren.

23. Verfahren nach Anspruch 22, **dadurch gekennzeichnet, daß** über die Steuerungsmodule (72) ein Abspeichern von Datensätzen aus dem Hauptspeicher (54) in den Steuerungsspeichermodulen (74) erfolgt.

24. Verfahren nach einem der Ansprüche 20 bis 23, **dadurch gekennzeichnet, daß** die Datensätze in dem Hauptspeicher (54) in einem volumenreduzierten Datenformat gespeichert sind und daß vor dem Einlesen der Datensätze in den Steuerungsspeicher (52) eine Wandlung in ein maschinennahes Datenformat durchgeführt wird.

25. Verfahren nach Anspruch 24, **dadurch gekennzeichnet, daß** das volumenreduzierte Datenformat ein Vektordatenformat ist.

26. Verfahren nach Anspruch 24 oder 25, **dadurch gekennzeichnet, daß** das maschinennahe Datenformat ein Pixeldatenformat ist.

27. Verfahren nach einem der Ansprüche 24 bis 26, **dadurch gekennzeichnet, daß** die Wandlung des Datenformats unmittelbar vor einer Datenübergabe an das Steuerungsmodul (72) erfolgt.

28. Verfahren nach einem der Ansprüche 22 bis 27, **dadurch gekennzeichnet, daß** die Steuerung (50) zum gleichzeitigen Ansteuern der Lichtquellen (44) Datensätze aus mehreren Steuerungsspeichereinheiten (62) erhält.

29. Verfahren nach einem der voranstehenden Ansprüche, **dadurch gekennzeichnet, daß** der der Steuerung (50) zugeordnete Steuerungsspeicher (52) zu Speicherung von mindestens zwei Makrozeilen (MZ) ausgelegt ist.

30. Verfahren nach einem der voranstehenden Ansprüche, **dadurch gekennzeichnet, daß** der der Steuerung (50) zugeordnete Steuerungsspeicher (52) zur Speicherung von weniger als der Hälfte der Vielzahl (M) von Makrozeilen (MZ) einer Baugruppe (34) ausgelegt ist.

31. Verfahren nach Anspruch 30, **dadurch gekennzeichnet, daß** der der Steuerung (50) zugeordnete Steuerungsspeicher (52) zur Speicherung von weniger als einem Viertel der Vielzahl (M) von Makrozeilen (MZ) einer Baugruppe (34) ausgelegt ist.

32. Verfahren nach einem der voranstehenden Ansprüche, **dadurch gekennzeichnet, daß** die Vielzahl (N) von Lichtquellen (44) aus einer Mehrzahl von Lichtquellengruppen (64) gebildet ist.

33. Verfahren nach Anspruch 32, **dadurch gekennzeichnet, daß** jeder Lichtquellengruppe (64) eine eigene Gruppensteuerung (70) zugeordnet ist und durch die Gruppensteuerung (70) die Lichtquellen (44) der Lichtquellengruppe (64) ausschließlich und unabhängig von den anderen Lichtquellengruppen (64) gesteuert werden.

34. Verfahren nach dem Oberbegriff des Anspruchs 1 oder nach einem der voranstehenden Ansprüche, **dadurch gekennzeichnet, daß** die Zahl (S) von Strukturzeilen (SZ), welche die Struktur (32) der Baugruppe (34) definieren, kleiner ist als die Gesamtzahl (G) der Zeilen (Z), in welchen mittels der Belichtungseinrichtung (10) eine Belichtung im Bereich der Baugruppe (34) durchgeführt werden kann, und daß eine Feinpositionierung in der Nebenrichtung (Y) durch eine Veränderung der Zuordnung der Strukturzeilen (SZ) zu den mit der Belichtungseinrichtung (10) belichtbaren Zeilen (Z) erfolgt.

35. Verfahren nach Anspruch 34, **dadurch gekennzeichnet, daß** die Veränderung der Zuordnung durch die Steuerung (50) ausgeführt wird.

36. Verfahren nach Anspruch 35, **dadurch gekennzeichnet, daß** in dem Steuerungsspeicher (52) zu jeder Makrozeile (MZ) Datensätze einer Zahl von Strukturzeilen (SZ) gespeichert werden, die größer ist als die Vielzahl (V) der im Bereich dieser Makrozeile (MZ) durch die Belichtungseinrichtung (10) belichtbaren Zeilen (Z).

37. Verfahren nach einem der Ansprüche 34 bis 36, **dadurch gekennzeichnet, daß** der Gruppensteuerung (70) Datensätze für eine Teilmenge der Strukturzeilen (SZ) der zu belichtenden Struktur (32) zur Verfügung gestellt werden, wobei die Zahl der Strukturzeilen (57) der Teilmenge größer ist als die tatsächlich von der Lichtquellengruppe (64) innerhalb eines Gruppenstreifens (GS) belichtbare Zahl der Zeilen (Z).

38. Verfahren nach Anspruch 37, **dadurch gekennzeichnet, daß** die nebeneinanderliegenden Lichtquellengruppen (64) zur Verfügung gestellten Datensätze von Teilmengen der Strukturzeilen (SZ) der zu belichtenden Struktur (32) Strukturzeilen (SZ) umfassen, die in beiden Teilmengen enthalten sind.

39. Verfahren nach Anspruch 38, **dadurch gekennzeichnet, daß** die in beiden Teilmengen enthaltenen Strukturzeilen (SZ) einen Überlappungsbereich (UB) bilden und daß die übrigen Strukturzeilen (SZ) der Teilmengen jeweils auf gegenüberliegenden Seiten des Überlappungsbereichs (UB) liegen.

40. Verfahren nach einem der voranstehenden Ansprüche, **dadurch gekennzeichnet, daß** mit jeder Lichtquelle (44) ein mehrere Zeilen (Z) umfassender Zeilenstreifen (ZS) belichtbar ist.

41. Verfahren nach dem Oberbegriff des Anspruchs 1 oder nach einem der voranstehenden Ansprüche, **dadurch gekennzeichnet, daß** mehrere Belichtungsvorrichtungen (A₁, A₂, B₁, B₂), jeweils umfassend einen Substratträger (26) und eine Belichtungseinrichtung (10), die eine Relativbewegung zueinander ausführen, eingesetzt werden.

42. Verfahren nach Anspruch 41, **dadurch gekennzeichnet, daß** bei zwei Belichtungsvorrichtungen (A₁, A₂, B₁, B₂) die Relativbewegungen in der Hauptrichtung (X) gegenläufig erfolgen.

43. Verfahren nach Anspruch 41 oder 42, **dadurch gekennzeichnet, daß** bei zwei Belichtungsvorrichtungen (A₁, A₂, B₁, B₂) die Relativbewegungen in der Nebenrichtung (Y) gegenläufig erfolgen.

44. Verfahren nach einem der Ansprüche 41 bis 43, **dadurch gekennzeichnet, daß** vier Belichtungsvorrichtungen (A₁, A₂, B₁, B₂) eingesetzt werden und daß jeweils paarweise die Relativbewegungen in der Hauptrichtung (X) und die Relativbewegungen in der Nebenrichtung (Y) gegenläufig erfolgen.

45. Vorrichtung zum Herstellen von belichteten Strukturen (32) auf mindestens einem Substratkörper (28) mittels einer Belichtungseinrichtung (10), bei welcher mindestens ein auf einem Substratträger (26) angeordneter Substratkörper (28) und die Belichtungseinrichtung (10) relativ zueinander in einer Hauptrichtung (X) und quer zu dieser in einer Nebenrichtung (Y) bewegbar sind, und daß die belichteten Strukturen (32) durch Belichten des Substratkörpers (28) innerhalb einer Vielzahl (M) von sich in der Hauptrichtung (X) erstreckenden und in der Nebenrichtung (Y) nebeneinanderliegenden Makrozeilen (MZ) herstellbar ist, daß jede der Makrozeilen (MZ) eine Vielzahl (V) von sich in der Hauptrichtung (X) erstreckenden und in der Nebenrichtung (Y) nebeneinanderliegenden Zeilen (Z) umfaßt, daß die Belichtungseinrichtung (10) eine Vielzahl (N) von Lichtquellen (44) und eine diese im wesentlichen gleichzeitig ansteuernde Steuerung (50) mit einem Steuerungsspeicher (52) aufweist, **dadurch gekennzeichnet, daß** aus diesem Steuerungsspeicher bereits abgespeicherte Datensätze der Makrozeile (MZ), in deren Bereich belichtet wird, auslesbar sind, werden können, während Datensätze einer weiteren Makrozeile (MZ) abspeicherbar sind.

46. Vorrichtung nach Anspruch 45, **dadurch gekennzeichnet, daß** zum Belichten der Vielzahl (V) von Zeilen (Z) einer Makrozeile (MZ) die gesamte Vielzahl (N) von Lichtquellen (44) der Belichtungseinrichtung (10) vorgesehen ist.

47. Vorrichtung nach Anspruch 45 oder 46, **dadurch gekennzeichnet, daß** der Steuerungsspeicher (52) über eine Schnittstelle (76) mit mindestens einem Hauptspeicher (54), der mindestens die Datensätze der Vielzahl (M) von Makrozeilen (MZ) einer Baugruppe (34) speichert, kommuniziert.

48. Vorrichtung nach einem der Ansprüche 45 bis 47, **dadurch gekennzeichnet, daß** der Steuerungsspeicher (52) mehrere Steuerungsspeichermodule (74) umfaßt und daß die Steuerung (50) mit den mehreren Steuerungsspeichermodulen (74) des Steuerungsspeichers (52) gleichzeitig kommuniziert.

49. Vorrichtung nach Anspruch 48, **dadurch gekennzeichnet, daß** mehrere Steuerungsspeichermodule (74) mittels eines Steuerungsmoduls (72) zu einer Steuerungsspeichereinheit (62) zusammengefaßt sind und über diese mit der Steuerung (50) kommunizieren.

50. Vorrichtung nach Anspruch 49, **dadurch gekennzeichnet, daß** über die Steuerungsmodule (72) ein Abspeichern von Datensätzen aus dem Hauptspeicher (54) in den Steuerungsspeichermodulen (74) erfolgt.

51. Verfahren nach einem der Ansprüche 47 bis 50, **dadurch gekennzeichnet, daß** die Datensätze in dem Hauptspeicher (54) in einem volumenreduzierten Datenformat gespeichert sind und daß die Datensätze vor dem Einlesen in den Steuerungsspeicher (52) durch einen Wandler in ein maschinennahes Datenformat umsetzbar sind.

52. Verfahren nach Anspruch 51, **dadurch gekennzeichnet, daß** das volumenreduzierte Datenformat ein Vektordatenformat ist.

53. Verfahren nach Anspruch 51 oder 52, **dadurch gekennzeichnet, daß** das maschinennahe Datenformat ein Pixeldatenformat ist.

54. Verfahren nach einem der Ansprüche 51 bis 53, **dadurch gekennzeichnet, daß** die Wandlung des Datenformats mit einem unmittelbar vor dem Steuerungsmodul (72) angeordneten Wandler erfolgt.

55. Vorrichtung nach einem der Ansprüche 49 oder 54, **dadurch gekennzeichnet, daß** die Steuerung (50) zum gleichzeitigen Ansteuern der Lichtquellen (44) Datensätze aus mehreren Steuerungsspeichereinheiten (62) erhält.

56. Vorrichtung nach einem der Ansprüche 45 bis 55, **dadurch gekennzeichnet, daß** der der Steuerung (50) zugeordnete Steuerungsspeicher (52) zu Speicherung von mindestens zwei Makrozeilen (MZ) ausgelegt ist.

57. Vorrichtung nach einem der Ansprüche 45 bis 56, **dadurch gekennzeichnet, daß** der der Steuerung (50) zugeordnete Steuerungsspeicher (52) zur Speicherung von weniger als der Hälfte der Vielzahl (M) von Makrozeilen (MZ) einer Baugruppe (34) ausgelegt ist.

58. Vorrichtung nach Anspruch 57, **dadurch gekennzeichnet, daß** der der Steuerung (50) zugeordnete Steuerungsspeicher (52) zur Speicherung von weniger als einem Viertel der Vielzahl (M) von Makrozeilen (MZ) einer Baugruppe (34) ausgelegt ist.

59. Vorrichtung nach einem der Ansprüche 45 bis 58, **dadurch gekennzeichnet, daß** die Vielzahl (N) von Lichtquellen (44) aus einer Mehrzahl von Lichtquellengruppen (64) gebildet ist.

60. Vorrichtung nach Anspruch 59, **dadurch gekennzeichnet, daß** jeder Lichtquellengruppe (64) eine eigene Gruppensteuerung (70) zugeordnet ist und durch die Gruppensteuerung (70) die Lichtquelle (44) der Lichtquellengruppe (64) ausschließlich und unabhängig von den anderen Lichtquellengruppen (64) gesteuert werden.

61. Vorrichtung nach einem der Ansprüche 45 bis 60, **dadurch gekennzeichnet, daß** mit jeder Lichtquelle (44) ein mehrere Zeilen (Z) umfassender Zeilenstreifen (ZS) belichtbar ist.

62. Vorrichtung nach dem Oberbegriff des Anspruchs 45 oder nach einem der Ansprüche 45 bis 61, **dadurch gekennzeichnet, daß** mehrere Belichtungsvorrichtungen (A₁, A₂, B₁, B₂), jeweils umfassend einen Substratträger (26) und eine Belichtungseinrichtung (10), die eine Relativbewegung zueinander ausführen, einsetzbar sind.

63. Vorrichtung nach Anspruch 62, **dadurch gekennzeichnet, daß** bei zwei Belichtungsvorrichtungen (A₁, A₂, B₁, B₂) die Relativbewegungen in der Hauptrichtung (X) gegenläufig erfolgen.

64. Vorrichtung nach Anspruch 62 oder 63, **dadurch gekennzeichnet, daß** bei zwei Belichtungsvorrichtungen (A₁, A₂, B₁, B₂) die Relativbewegungen in der Nebenrichtung (Y) gegenläufig erfolgen.

65. Vorrichtung nach einem der Ansprüche 62 bis 64, **dadurch gekennzeichnet, daß** vier Belichtungsvorrichtungen (A₁, A₂, B₁, B₂) eingesetzt werden und daß jeweils paarweise die Relativbewegungen in der Hauptrichtung (X) und die Relativbewegungen in der Nebenrichtung (Y) gegenläufig erfolgen.

## Claims

1. Method for producing exposed structures (32) on a plurality of components (34) arranged on at least one substrate member (28) by means of an exposure unit (10), wherein at least one substrate member (28) arranged on a substrate carrier (26) and the exposure unit (10) are moved relative to one another in a main direction (X) and transversely to this in a secondary direction (Y), wherein identical structures are produced on at least some of the components (34), wherein each of the identical structures (32) is produced by way of exposure of the substrate member (28) in the area of the component (34) respectively provided within a plurality (M) of macrolines (MZ) extending in the main direction (X) and lying next to one another in the secondary direction (Y), wherein each of the macrolines (MZ) comprises a plurality (V) of lines (Z) extending in the main direction (X) and lying next to one another in the secondary direction (Y), **characterized in that** during a single pass along a path of exposure (W) all the components (34) to be provided with identical structures and covered by this path of exposure (W) are exposed with the exposure unit (10) in the area of the same macroline (MZ) of the plurality (M) of macrolines (MZ), that the exposure unit (10) has a plurality (N) of light sources (44) and a control (50) activating them essentially at the same time and having a control memory (52) constructed such that sets of data already stored for the macroline (MZ), in the area of which exposure is being carried out, are able to be read from this control memory (52) while sets of data of an additional macroline (MZ) are being stored.

2. Method as defined in claim 1, **characterized in that** the path of exposure (W) is selected to be at least of such a length that the time for passing along the same corresponds at least to the time required for storing at least half the sets of data of the additional macroline (MZ) in the control memory (52).

3. Method as defined in claim 2, **characterized in that** the path of exposure (W) is selected to be at least of such a length that the time for passing along the same corresponds at least to the time required for storing at least two thirds of the sets of data of the additional macroline (MZ) in the control memory (52).

4. Method as defined in any one of the preceding claims, **characterized in that** the path of exposure (W) is selected to be at least of such a length that the time for passing along the same corresponds at least to the time required for storing the sets of data of the additional macroline (MZ) in the control memory (52).

5. Method as defined in any one of the preceding claims, **characterized in that** the path of exposure (W) extends over only one substrate member (28).

6. Method as defined in any one of the preceding claims, **characterized in that** the path of exposure (W) extends over several substrate members (28).

7. Method as defined in any one of the preceding claims, **characterized in that** the path of exposure (W) extends in a straight line in the main direction (X).

8. Method as defined in any one of the preceding claims, **characterized in that** the path of exposure (W) extends in the main direction (X) and the secondary direction (Y).

9. Method as defined in claim 7, **characterized in that** the path of exposure (W) extends exclusively and in a straight line in the main direction (X).

10. Method as defined in any one of claims 1 to 8, **characterized in that** the path of exposure (W) extends in a meandering shape.

11. Method as defined in any one of the preceding claims, **characterized in that** the components (34) are arranged on the substrate members (28) in rows (36) extending parallel to the main direction (X).

12. Method as defined in claim 11, **characterized in that** the path of exposure (W) covers at least one row (36) of components (34).

13. Method as defined in claim 12, **characterized in that** the path of exposure (W) covers all the components (34) arranged in a row (36) extending in the main direction (X) on one substrate carrier (26).

14. Method as defined in claim 12 or 13, **characterized in that** the path of exposure (W) covers several rows (36) of components (34).

15. Method as defined in claim 14, **characterized in that** the several rows (36) of components (34) are located next to one another.

16. Method as defined in any one of claims 12 to 15, **characterized in that** the path of exposure (W) covers one row (36) of components (34) in the main direction (X) and then switches transversely to the main direction (X) to an additional row (36) of components (34) and covers them.

17. Method as defined in claim 16, **characterized in that** the path of exposure (W) passes along the additional row (36) in the opposite direction of travel to the one row (36).

18. Method as defined in claim 16 or 17, **characterized in that** the additional row (36) is the next row (36) following the one row (36) in the secondary direction (Y).

19. Method as defined in any one of the preceding claims, **characterized in that** the entire plurality (N) of light sources (44) of the exposure unit (10) is provided for the exposure of the plurality (V) of lines (Z) of one macroline (MZ).

20. Method as defined in any one of the preceding claims, **characterized in that** the control memory (52) communicates via an interface (76) with at least one main memory (54) storing at least the sets of data of the plurality (M) of macrolines (MZ) of one component (34).

21. Method as defined in any one of the preceding claims, **characterized in that** the control memory (52) comprises several control memory modules (74) and that the control (50) communicates with the several control memory modules (74) of the control memory (52) at the same time.

22. Method as defined in claim 21, **characterized in that** several control memory modules (74) are combined by means of a control module (72) to form a control memory unit (62) and communicate via this with the control (50).

23. Method as defined in claim 22, **characterized in that** sets of data from the main memory (54) are stored in the control memory modules (74) via the control modules (72).

24. Method as defined in any one of claims 20 to 23, **characterized in that** the sets of data are stored in the main memory (54) in a volume-reduced data format and that prior to the sets of data being read into the control memory (52) a conversion into a machine-oriented data format is carried out.

25. Method as defined in claim 24, **characterized in that** the volume-reduced data format is a vector data format.

26. Method as defined in claim 24 or 25, **characterized in that** the machine-oriented data format is a pixel data format.

27. Method as defined in any one of claims 24 to 26, **characterized in that** the conversion of the data format takes place immediately prior to a transfer of data to the control module (72).

28. Method as defined in any one of claims 22 to 27, **characterized in that** the control (50) receives sets of data from several control memory units (62) for the simultaneous activation of the light sources (44).

29. Method as defined in any one of the preceding claims, **characterized in that** the control memory (52) associated with the control (50) is designed for storing at least two macrolines (MZ).

30. Method as defined in any one of the preceding claims, **characterized in that** the control memory (52) associated with the control (50) is designed for storing less than half the plurality (M) of macrolines (MZ) of a component (34).

31. Method as defined in claim 30, **characterized in that** the control memory (52) associated with the control (50) is designed for storing less than a quarter of the plurality (M) of macrolines (MZ) of a component (34).

32. Method as defined in any one of the preceding claims, **characterized in that** the plurality (N) of light sources (44) is formed from a plurality of groups (64) of light sources.

33. Method as defined in claim 32, **characterized in that** each group (64) of light sources has its own group control (70) associated with it and the light sources (44) of the group (64) of light sources are controlled by the group control (70) exclusively and independently of the other groups (64) of light sources.

34. Method as defined in the preamble to claim 1 or as defined in any one of the preceding claims, **characterized in that** the number (S) of structure lines (SZ) defining the structure (32) of the component (34) is smaller than the total number (G) of lines (Z), an exposure in the area of the component (34) being carried out in these lines by means of the exposure unit (10), and that a fine positioning in the secondary direction (Y) is brought about by a change in the allocation of the structure lines (SZ) to the lines (Z) exposable with the exposure unit (10).

35. Method as defined in claim 34, **characterized in that** the change in the allocation is carried out by the control (50).

36. Method as defined in claim 35, **characterized in that** sets of data of a number of structure lines (SZ) are stored for each macroline (MZ) in the control memory (52), said number of structure lines being greater than the plurality (V) of the lines (Z) exposable by the exposure unit (10) in the area of this macroline (MZ).

37. Method as defined in any one of claims 34 to 36, **characterized in that** sets of data for a subset of the structure lines (SZ) of the structure (32) to be exposed are made available to the group control (70), wherein the number of the structure lines (57) of the subset is greater than the number of the lines (Z) actually exposable by the group (64) of light sources within a group strip (GS).

38. Method as defined in claim 37, **characterized in that** the sets of data of subsets of the structure lines (SZ) of the structure (32) to be exposed, said sets of data being made available to the groups (64) of light sources located next to one another, comprise structure lines (SZ) contained in both subsets.

39. Method as defined in claim 38, **characterized in that** the structure lines (SZ) contained in both subsets form an overlapping area (UB) and that the remaining structure lines (SZ) of the subsets are respectively located on opposite sides of the overlapping area (UB).

40. Method as defined in any one of the preceding claims, **characterized in that** a line strip (ZS) comprising several lines (Z) is exposable with each light source (44).

41. Method as defined in the preamble to claim 1 or as defined in any one of the preceding claims, **characterized in that** several exposure devices (A₁, A₂, B₁, B₂), each comprising a substrate carrier (26) and an exposure unit (10) carrying out a relative movement in relation to one another, are used.

42. Method as defined in claim 41, **characterized in that** with two exposure devices (A₁, A₂, B₁, B₂) the relative movements in the main direction (X) take place in opposite directions.

43. Method as defined in claim 41 or 42, **characterized in that** with two exposure devices (A₁, A₂, B₁, B₂) the relative movements in the secondary direction (Y) take place in opposite directions.

44. Method as defined in any one of claims 41 to 43, **characterized in that** four exposure devices (A₁, A₂, B₁, B₂) are used and that for respective pairs the relative movements in the main direction (X) and the relative movements in the secondary direction (Y) take place in opposite directions.

45. Device for producing exposed structures (32) on at least one substrate member (28) by means of an exposure unit (10), wherein at least one substrate member (28) arranged on a substrate carrier (26) and the exposure unit (10) are movable relative to one another in a main direction (X) and transversely to this in a secondary direction (Y), and that the exposed structures (32) are producible by way of exposure of the substrate member (28) within a plurality (M) of macrolines (MZ) extending in the main direction (X) and lying next to one another in the secondary direction (Y), that each of the macrolines (MZ) comprises a plurality (V) of lines (Z) extending in the main direction (X) and lying next to one another in the secondary direction (Y), that the exposure unit (10) has a plurality (N) of light sources (44) and a control (50) activating them essentially at the same time and having a control memory (52), **characterized in that** sets of data already stored for the macroline (MZ), in the area of which exposure is being carried out, are readable from this control memory while sets of data of an additional macroline (MZ) are being stored.

46. Device as defined in claim 45, **characterized in that** the entire plurality (N) of light sources (44) of the exposure unit (10) is provided for the exposure of the plurality (V) of lines (Z) of a macroline (MZ).

47. Device as defined in claim 45 or 46, **characterized in that** the control memory (52) communicates via an interface (76) with at least one main memory (54) storing at least the sets of data of the plurality (M) of macrolines (MZ) of one component (34).

48. Device as defined in any one of claims 45 to 47, **characterized in that** the control memory (52) comprises several control memory modules (74) and that the control (50) communicates with the several control memory modules (74) of the control memory (52) at the same time.

49. Device as defined in claim 48, **characterized in that** several control memory modules (74) are combined by means of a control module (72) to form a control memory unit (62) and communicate via this with the control (50).

50. Device as defined in claim 49, **characterized in that** sets of data from the main memory (54) are stored in the control memory modules (74) via the control modules (72).

51. Method as defined in any one of claims 47 to 50, **characterized in that** the sets of data are stored in the main memory (54) in a volume-reduced data format and that the sets of data are convertible into a machine-oriented data format by a converter prior to being read into the control memory (52).

52. Method as defined in claim 51, **characterized in that** the volume-reduced data format is a vector data format.

53. Method as defined in claim 51 or 52, **characterized in that** the machine-oriented data format is a pixel data format.

54. Method as defined in any one of claims 51 to 53, **characterized in that** the conversion of the data format takes place with a converter arranged directly in front of the control module (72).

55. Device as defined in one of claims 49 or 54, **characterized in that** the control (50) receives sets of data from several control memory units (62) for the simultaneous activation of the light sources (44).

56. Device as defined in any one of claims 45 to 55, **characterized in that** the control memory (52) associated with the control (50) is designed for storing at least two macrolines (MZ).

57. Device as defined in any one of claims 45 to 56, **characterized in that** the control memory (52) associated with the control (50) is designed for storing less than half the plurality (M) of macrolines (MZ) of a component (34).

58. Device as defined in claim 57, **characterized in that** the control memory (52) associated with the control (50) is designed for storing less than a quarter of the plurality (M) of macrolines (MZ) of a component (34).

59. Device as defined in any one of claims 45 to 58, **characterized in that** the plurality (N) of light sources (44) is formed from a plurality of groups (64) of light sources.

60. Device as defined in claim 59, **characterized in that** each group (64) of light sources has its own group control (70) associated with it and the light sources (44) of the group (64) of light sources are controlled by the group control (70) exclusively and independently of the other groups (64) of light sources.

61. Device as defined in any one of claims 45 to 60, **characterized in that** a line strip (ZS) comprising several lines (Z) is exposable with each light source (44).

62. Device as defined in the preamble to claim 45 or as defined in any one of claims 45 to 61, **characterized in that** several exposure devices (A₁, A₂, B₁, B₂), each comprising a substrate carrier (26) and an exposure unit (10) carrying out a relative movement in relation to one another, are used.

63. Device as defined in claim 62, **characterized in that** with two exposure devices (A₁, A₂, B₁, B₂) the relative movements in the main direction (X) take place in opposite directions.

64. Device as defined in claim 62 or 63, **characterized in that** with two exposure devices (A₁, A₂, B₁, B₂) the relative movements in the secondary direction (Y) take place in opposite directions.

65. Device as defined in any one of claims 62 to 64, **characterized in that** four exposure devices (A₁, A₂, B₁, B₂) are used and that for respective pairs the relative movements in the main direction (X) and the relative movements in the secondary direction (Y) take place in opposite directions.

## Revendications

1. Procédé de génération de structures exposées (32) sur une pluralité de composants ou éléments (34) disposés sur au moins un corps de substrat (28), au moyen d'un dispositif d'exposition (10), avec lequel on déplace au moins un corps de substrat (28) disposé sur un support de substrat (26) et le dispositif d'exposition (10) l'un par rapport à l'autre dans une direction principale (X) et à la transversale de cette dernière dans une direction auxiliaire (Y), des structures identiques étant créées sur au moins une partie des composants ou éléments (34), chacune des structures identiques (32) étant créée par exposition du corps de substrat (28) dans la région du composant ou élément respectivement prévue (34) au sein d'une pluralité (M) de macro lignes (MZ) s'étendant dans la direction principale (X) et placées côte à côte dans la direction auxiliaire (Y), chacune des macro lignes (MZ) comportant une pluralité (V) de lignes (Z) s'étendant dans la direction principale (X) et placées côte à côte dans la direction auxiliaire (Y), **caractérisée en ce que** lors d'un passage unique d'un trajet d'exposition (W), on soumet à l'exposition tous les composants ou éléments (34) englobés par ce trajet d'exposition (W) et devant être munis de structures identiques dans la région de la même macro ligne (MZ) de la pluralité (M) de macro lignes (MZ) avec le dispositif d'exposition (10), **en ce que** le dispositif d' exposition (10) comporte une pluralité (N) de sources lumineuses (44) et un système de commande (50) actionnant ces dernières de façon sensiblement simultanée avec une mémoire de commande (52) qui est conçue de façon à ce que dans cette mémoire de commande (52), on puisse lire des jeux de données d'ores et déjà sauvegardés de la macro ligne (MZ) dans la région de laquelle on procède à l'exposition, pendant qu'on sauvegarde des jeux de données d'une autre macro ligne passe(MZ).

2. Procédé selon la revendication 1, **caractérisé en ce qu'**on opte pour un trajet d'exposition (W) au moins assez long, pour que le temps de passage de ce dernier corresponde au moins au temps qui est nécessaire pour sauvegarder au moins la moitié des jeux de données de l'autre macro ligne (MZ) dans la mémoire de commande (52).

3. Procédé selon la revendication 2, **caractérisé en ce qu'**on opte pour un trajet d'exposition (W) au moins assez long, pour que le temps de passage de ce dernier corresponde au moins au temps qui est nécessaire pour sauvegarder au moins deux tiers des jeux de données de l'autre macro ligne (MZ) dans la mémoire de commande (52).

4. Procédé selon l'une quelconque des revendications précédentes, **caractérisé en ce qu'**on opte pour un trajet d'exposition (W) au moins assez long pour que le temps de passage de ce dernier corresponde au moins au temps qui est nécessaire pour sauvegarder les jeux de données de l'autre macro ligne (MZ) dans la mémoire de commande (52).

5. Procédé selon l'une quelconque des revendications précédentes, **caractérisé en ce que** le trajet d'exposition (W) s'étend sur un seul corps de substrat (28).

6. Procédé selon l'une quelconque des revendications précédentes, **caractérisé en ce que** le trajet d'exposition (W) s'étend sur plusieurs corps de substrats (28).

7. Procédé selon l'une quelconque des revendications précédentes, **caractérisé en ce que** le trajet d'exposition (W) s'étend de façon rectiligne dans la direction principale (X).

8. Procédé selon l'une quelconque des revendications précédentes, **caractérisé en ce que** le trajet d'exposition (W) s'étend dans la direction principale (X) et dans la direction auxiliaire (Y).

9. Procédé selon la revendication 7, **caractérisé en ce que** le trajet d'exposition (W) s'étend exclusivement et de façon rectiligne dans la direction principale (X).

10. Procédé selon l'une quelconque des revendications 1 à 8, **caractérisé en ce que** le trajet d'exposition (W) s'étend en forme de méandres.

11. Procédé selon l'une quelconque des revendications précédentes, **caractérisé en ce que** les composants ou éléments (34) sont disposés en rangées (36) s'étendant à la parallèle de la direction prin-cipale (X) sur les corps de substrats (28).

12. Procédé selon la revendication 11, **caractérisé en ce que** le trajet d'exposition (W) englobe au moins une rangée (36) de composants ou éléments (34).

13. Procédé selon la revendication 12, **caractérisé en ce que** le trajet d'exposition (W) englobe tous les composants ou éléments (34) disposés dans une rangée (36) s'étendant dans la direction principale sur un support de substrat (26).

14. Procédé selon la revendication 12 ou 13, **caractérisé en ce que** le trajet d'exposition (W) englobe plusieurs rangées (36) de composants ou éléments (34).

15. Procédé selon la revendication 14, **caractérisé en ce que** les plusieurs rangées (36) de composants ou d'éléments (34) sont placées côte à côte.

16. Procédé selon l'une quelconque des revendications 12 à 15, **caractérisé en ce que** dans la direction principale (X), le trajet d'exposition (W) englobe une rangée (36) de composants ou éléments (34), puis passe ensuite, à la transversale de la direction principale (x) à une autre rangée (36) de composants ou éléments (34) et l'englobe.

17. Procédé selon la revendication 16, **caractérisé en ce que** le trajet d'exposition (W) trainversé à celui de la rangée en question (36).

18. Procédé selon la revendication 16 ou 17, **caractérisé en ce que** l'autre rangée (36) est la rangée directement consécutive (36) à la rangée en question (36), dans la direction auxiliaire (Y).

19. Procédé selon l'une quelconque des revendications précédentes, **caractérisé en ce que** pour l'exposition de la pluralité (V) de lignes (Z) d'une macro ligne (MZ), on a prévu l'ensemble de la pluralité (N) de sources lumineuses (44) du dispositif d'exposition (10).

20. Procédé selon l'une quelconque des revendications précédentes, **caractérisé en ce que** par l'intermédiaire d'une interface (76), la mémoire de commande (52) communique avec au moins une mémoire principale (54) dans laquelle sont sauvegardés au moins les jeux de données de la pluralité (M) de macro lignes (MZ) d'un composant ou élément (34).

21. Procédé selon l'une quelconque des revendications précédentes, **caractérisé en ce que** la mémoire de commande (52) comporte plusieurs modules de mémoire de commande (74) et **en ce que** le système de commande (50) communique avec les plusieurs modules de mémoire de commande (74) de la mémoire de commande (52).

22. Procédé selon la revendication 21, **caractérisé en ce que** plusieurs modules de mémoire de commande (74) sont regroupés au moyen d'un module de commande (72) en une unité de mémoire de commande (62) et communiquent par l'intermédiaire de cette dernière avec le système de commande (50).

23. Procédé selon la revendication 22, **caractérisé en ce que** par l'intermédiaire des modules de commande (72) on assure une sauvegarde de jeux de données à partir de la mémoire principale (54) dans les modules de mémoire de commande (74).

24. Procédé selon l'une quelconque des revendications 20 à 23, **caractérisé en ce que** les jeux de données sont sauvegardés dans la mémoire principale (54) dans un format de données à volume réduit et **en ce qu'**avant la lecture des jeux de données dans la mémoire de commande (52), on procède à une transformation en un format de données compatible informatique.

25. Procédé selon la revendication 24, **caractérisé en ce que** le format à volume réduit est un format de données vectoriel.

26. Procédé selon la revendication 24 ou 25, **caractérisé en ce que** le format des données compatible informatique est un format de données par pixels.

27. Procédé selon l'une quelconque des revendications 24 à 26, **caractérisé en ce que** la transformation du format de données est assurée directement avant un transfert de données au module de commande (72).

28. Procédé selon l'une quelconque des revendications 22 à 27, **caractérisé en ce que** le système de commande (50) contient des jeux de données de plusieurs unités de mémoire de commande (62) pour l'actionnement simultané des sources lumineuses (44).

29. Procédé selon l'une quelconque des revendications précédentes, **caractérisé en ce que** la mémoire de commande (52) associée au système de commande (50) est conçue pour sauvegarder au moins deux macro lignes (MZ).

30. Procédé selon l'une quelconque des revendications précédentes, **caractérisé en ce que** la mémoire de commande (52) associée au système de commande (50) est conçue pour sauvegarder moins de la moitié de la pluralité (M) de macro lignes (MZ) d'un composant ou élément (34).

31. Procédé selon la revendication 30, **caractérisé en ce que** la mémoire de commande (52) associée au système de commande (50) est conçue pour sauvegarder moins d'un quart de la pluralité (M) de macro lignes (MZ) d'un composant ou élément (34).

32. Procédé selon l'une quelconque des revendications précédentes, **caractérisé en ce que** la pluralité (N) de sources lumineuses (44) est constituée d'une pluralité de groupes de sources lumineuses (64).

33. Procédé selon la revendication 32, **caractérisé en ce qu'**un propre système de commande de groupe (70) est associé à chaque groupe de sources lumineuses (64) et **en ce que** les sources lumineuses (44) du groupe de sources lumineuses (64) sont commandées par le système de commande de groupe (70) exclusivement et indépendamment des autres groupes de sources lumineuses (64).

34. Procédé selon le préambule de la revendication 1 ou selon l'une quelconque des revendications précédentes, **caractérisé en ce que** le nombre (S) des lignes structurelles (SZ) qui définissent la structure (32) des composants ou éléments (34) est inférieur au nombre total (G) des lignes (Z) dans lesquelles, au moyen du dispositif d'exposition (10), on peut procéder à une exposition dans la région des composants ou éléments (34) et **en ce qu'**un positionnement fin dans la direction auxiliaire (Y) est assuré par une modification de l'association des lignes struc-turelles (SZ) aux lignes pouvant être soumises à l'exposition (Z), à l'aide du dispositif d'expo-sition (10).

35. Procédé selon la revendication 34, **caractérisé en ce que** la modification de l'association est réalisée par le système de commande (50).

36. Procédé selon la revendication 35, **caractérisé en ce que** dans la mémoire de commande (52), on sauvegarde pour chaque macro ligne (MZ) des jeux de données d'un nombre de lignes structurelles (SZ) qui est plus grand que la pluralité (V) des lignes (Z) pouvant être soumises à l'exposition du dispositif d'exposition (10) dans la région de cette macro ligne (MZ).

37. Procédé selon l'une quelconque des revendications 34 à 36, **caractérisé en ce qu'**on met à la disposition du système de commande de groupe (70) des jeux de données pour une quantité partielle des lignes structurelles (SZ) de la structure (32) devant être soumise à l'exposition, le nombre des lignes structurelles (57) de la quantité partielle étant supérieur au nombre de lignes (z) effectivement soumises à l'exposition du groupe de sources lumineuses (64) au sein d'une bande de groupes (GS).

38. Procédé selon la revendication 37, **caractérisé en ce que** les groupes de sources lumineuses situés côte à côte (64) de jeux de données mis à disposition de quantités partielles de lignes structurelles (SZ) de la structure (32) devant être soumise à l'exposition comprennent des lignes structurelles (SZ), qui sont contenues dans les deux quantités partielles.

39. Procédé selon la revendication 38, **caractérisé en ce que** les lignes structurelles (SZ) contenues dans les deux quantités partielles forment une zone de chevauchement (UB) et **en ce que** les autres lignes structurelles (SZ) des quantités partielles se situent respectivement sur des côtés opposés de la zone de chevauchement (UB).

40. Procédé selon l'une quelconque des revendications précédentes, **caractérisé en ce qu'**avec chaque source lumineuse (44), on peut soumettre à l'exposition une bande de lignes (ZS) comprenant plusieurs lignes (Z).

41. Procédé selon le préambule de la revendication 1 ou selon l'une quelconque des revendications précédentes, **caractérisé en ce qu'**on utilise plusieurs appareils d'exposition (A₁, A₂, B₁, B₂), comprenant chacun un support de substrat (26) et un dispositif d'exposition (10), qui se déplacent mutuellement l'un par rapport à l'autre.

42. Procédé selon la revendication 41, **caractérisé en ce que** dans le cas de deux appareils d'exposition, (A₁, A₂, B₁, B₂), les déplacements relatifs sont assurés en sens opposé dans la direction principale (X).

43. Procédé selon la revendication 41 ou 42, **caractérisé en ce que** dans le cas de deux appareils d'exposition, (A₁, A₂, B₁, B₂), les déplacements relatifs sont assurés en sens contraire, dans la direction auxiliaire (Y).

44. Procédé selon l'une quelconque des revendications 41 à 43, **caractérisé en ce qu'**on utilise quatre appareils d'exposition (A₁, A₂, B₁, B₂), et **en ce que** respectivement les déplacements relatifs dans la direction principale (X) sont effectués par paires et les déplacements rela-tifs dans la direction auxiliaire (Y) sont effectués en sens contraire.

45. Dispositif de génération de structures exposées (32) sur au moins un corps de substrat (28), au moyen d'un dispositif d'exposition (10) sur lequel au moins un corps de substrat (28) disposé sur un support de substrat (26) et le dispositif d'exposition (10) sont déplaçables l'un par rapport à l'autre dans une direction principale (X) et à la transversale de cette dernière, dans une direction auxiliaire (Y) et les structures soumises à l'exposition (32) pouvant être créées par exposition du corps de substrat (28) au sein d'une pluralité (M) de macro lignes (MZ) s'étendant dans une direction principale (X) et étant placées côte à côte dans la direction auxiliaire (Y), et chacune des macro lignes (MZ) comprenant une pluralité (V) de lignes (Z) s'étendant en direction principale (X) et placées côte à côte dans la direction auxiliaire (Y), le dispositif d'exposition (10) comportant une pluralité (N) de sources lumineuses (44) et un système de commande (50) actionnant ces dernières de façon sensiblement simultanée, avec une mémoire de commande (52), **caractérisé en ce que** des jeux de données de la macro ligne (MZ) dans les régions de laquelle on procède à l'exposition, peuvent être lus, pendant que des jeux de données d'une autre macro ligne (MZ) peuvent être sauvegardés.

46. Dispositif selon la revendication 45, **caractérisé en ce que** pour l'exposition de la pluralité (V) de lignes (Z) d'une macro ligne (MZ), on a prévu la pluralité entière (N) de sources lumineuses (44) du dispositif d'exposition (10).

47. Dispositif selon la revendication 45 ou 46, **caractérisé en ce que** la mémoire de commande (52) communique par l'intermédiaire d'une interface (76) avec au moins une mémoire principale (54), qui sauvegarde au moins les jeux de données de la pluralité (M) de macro lignes (MZ) d'un composant ou élément (34).

48. Dispositif selon l'une quelconque des revendications 45 à 47, **caractérisé en ce que** la mémoire de commande (52) comprend plusieurs modules de mémoire de commande (74) et **en ce que** le système de commande (50) communique simultanément avec les plusieurs modules de mémoire de commande (74) de la mémoire de commande (52).

49. Dispositif selon la revendication 48, **caractérisé en ce que** plusieurs modules de mémoire de commande (74) sont regroupés au moyen d'un module de commande (72) en une unité de mémoire de commande (62) et communiquent par l'intermédiaire de cette dernière avec le système de commande (50).

50. Dispositif selon la revendication 49, **caractérisé en ce qu'**une sauvegarde de jeux de données à partir de la mémoire principale (54) est assurée dans les modules de mémoire de commande (74), par l'intermédiaire des modules de commande (72).

51. Procédé selon l'une quelconque des revendications 47 à 50, **caractérisé en ce que** les jeux de données sont sauvegardés dans la mémoire principale (54), sous un format de données à volume réduit et **en ce que** les jeux de données peuvent être transformés dans un format de données compatible informatique par un transformateur, avant leur lecture dans la mémoire de commande (52).

52. Procédé selon la revendication 51, **caractérisé en ce que** le format de données à volume réduit est un format de données vectoriel.

53. Procédé selon la revendication 51 ou 52, **caractérisé en ce que** le format de données compatible informatique est un format de données en pixel.

54. Procédé selon l'une quelconque des revendications 51 à 53, **caractérisé en ce que** la transformation du format de données est assurée par un transformateur immédiatement disposé à l'avant du module de commande (72).

55. Dispositif selon l'une quelconque des revendications 49 à 54, **caractérisé en ce que** le système de commande (50) contient des jeux de données issus de plusieurs unités de mémoire de commande (62), pour l'actionnement simultané des sources lumineuses (44).

56. Dispositif selon l'une quelconque des revendications 45 à 55, **caractérisé en ce que** la mémoire de commande (52) associée au système de commande (50) est conçue pour sauvegarder au moins deux macro lignes (MZ).

57. Dispositif selon l'une quelconque des revendications 45 à 56, **caractérisé en ce que** la mémoire de commande (52) associée au système de commande (50) est conçue pour la sauvegarde de moins de la moitié de la pluralité (M) de macro lignes (MZ) d'un composant ou élément (34).

58. Dispositif selon la revendication 57, **caractérisé en ce que** la mémoire de commande (52) associée au système de commande (50) est conçue pour la sauvegarde de moins d'un quart de la pluralité (M) de macro lignes (MZ) d'un composant ou élément (34).

59. Dispositif selon l'une quelconque des revendications 45 à 58, **caractérisé en ce que** la pluralité (N) de sources lumineuses (44) est formée d'une pluralité de groupes de sources lumineuses (64).

60. Dispositif selon la revendication 59, **caractérisé en ce qu'**un propre système de commande de groupe (70) est associé à chaque groupe de sources lumineuses (64) et la source lumineuse (44) du groupe de sources lumineuses (64) est commandée exclusivement et indépendamment des autres groupes de sources lumineuses (64) par le système de commande de groupe (70).

61. Dispositif selon l'une quelconque des revendications 45 à 50, **caractérisé en ce qu'**une bande de lignes (ZS) comprenant plusieurs lignes (Z) peut être soumise à l'exposition avec chaque source lumineuse (44).

62. Dispositif selon le préambule de la revendication 45 ou selon l'une quelconque des revendications 45 à 61, **caractérisé en ce qu'**on peut utiliser plusieurs appareils d'exposition (A₁, A₂, B₁, B₂) comprenant chacun un support de substrat (26) et un dispositif d'exposition (10), exerçant un déplacement mutuel l'un par rapport à l'autre.

63. Dispositif selon la revendication 62, **caractérisé en ce que** sur deux appareils d'exposition (A₁, A₂, B₁, B₂), les déplacements relatifs sont effectués dans la direction principale (X), à contresens.

64. Dispositif selon la revendication 62 ou 63, **caractérisé en ce que** sur deux appareils d'exposition (A₁, A₂, B₁, B₂), les déplacements relatifs sont assurés dans la direction auxiliaire (Y), en sens opposé.

65. Dispositif selon l'une quelconque des revendications 62 à 64, **caractérisé en ce qu'**on utilise quatre appareils d'exposition (A₁, A₂, B₁, B₂) et **en ce que** les déplacements relatifs dans la direction principale (X) et les déplacements relatifs dans la direction auxiliaire (Y) sont effectués en sens opposé, par paires.
